(19) Europäisches Patentamt
European Patent Office
Office européen des brevets

(11) **EP 4 366 484 A1**

(12) **EUROPEAN PATENT APPLICATION**

(43) Date of publication:
**08.05.2024 Bulletin 2024/19**

(21) Application number: **23205882.6**

(22) Date of filing: **25.10.2023**

(51) International Patent Classification (IPC):
**H10K 59/122** (2023.01)     **H10K 59/65** (2023.01)
**H10K 59/131** (2023.01)

(52) Cooperative Patent Classification (CPC):
**H10K 59/65; H10K 59/122;** H10K 59/131

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.11.2022 KR 20220143805**

(71) Applicant: **Samsung Display Co., Ltd.
Yongin-si, Gyeonggi-do 17113 (KR)**

(72) Inventors:
• **CHOI, Chung Sock
  Yongin-si (KR)**
• **YOO, Byung Han
  Yongin-si (KR)**
• **KO, Yoo Min
  Yongin-si (KR)**
• **PARK, Ju Chan
  Yongin-si (KR)**
• **LEE, Dae-Young
  Yongin-si (KR)**

(74) Representative: **Marks & Clerk LLP
15 Fetter Lane
London EC4A 1BW (GB)**

(54) **LIGHT EMITTING DISPLAY DEVICE**

(57) Embodiments provide an emissive display device including a light emitting diode that includes a first circuit part disposed in a display area and a cathode electrically connected to the first circuit part; and a non-emissive element (PD) that includes a second circuit part disposed in the display area and a cathode electrically connected to the second circuit part, and the cathode of the non-emissive element is separated from the cathode of the light emitting diode by a separator (SEP-PD).

FIG. 1

EP 4 366 484 A1

**Description**

BACKGROUND

1. Technical Field

The disclosure relates to an emissive display device, and, to an emissive display device including a sensing unit in a display area.

2. Description of the Related Art

A display device displays a screen, and may include a liquid crystal display, an organic light emitting diode display, and the like. Such a display device is used in various electronic devices such as mobile phones, navigation units, digital cameras, electronic books, portable game machines, and various terminals.

A display device such as an organic light emitting diode display may have a structure in which the display device can be bent or folded using a flexible substrate.

A structure of a pixel used in the organic light emitting diode display is being developed in various directions.

A display device including an emissive display device is being developed to include a sensor in a display area so as to enable sensing as well as display of an image.

The above information disclosed in this background section is only for enhancement of understanding of the background of the described technology, and therefore, it may contain information that does not form the prior art that may already be known to a person of ordinary skill in the art.

SUMMARY

Embodiments have been made in an effort to provide an emissive display device in which a sensing unit including a non-emissive element is also formed next to a display unit in a display area.

The technical objectives to be achieved by the disclosure are not limited to those described herein, and other technical objectives that are not mentioned herein would be clearly understood by a person skilled in the art from the description of the disclosure.

An embodiment provides an emissive display device that may include a light emitting diode that includes a first circuit part disposed in a display area and a cathode electrically connected to the first circuit part; and a non-emissive element that includes a second circuit part disposed in the display area and a cathode electrically connected to the second circuit part, wherein the cathode of the non-emissive element is separated from the cathode of the light emitting diode by a separator.

The separator may surround the cathode of the non-emissive element, and may include a non-emissive element separator having a substantially tapered shape or a substantially different angle at opposite sides.

The cathode of the non-emissive element may be electrically connected to a first separator upper conductive layer disposed on top of the non-emissive element separator, and the first separator upper conductive layer disposed on top of the non-emissive separator and a second separator upper conductive layer disposed on top of the separator may be electrically connected to each other, the cathode of the non-emissive element is electrically connected to a cathode of the another non-emissive element disposed at a distance from the cathode of the non-emissive element through the second separator upper conductive layer disposed on top of the separator and the first separator upper conductive layer disposed on top of the non-emissive element separator.

The separator may surround the cathode of the non-emissive element, and may have a same substantially tapered shape or a substantially angle on opposite side surfaces.

A cathode disposed in a light receiving area where the non-emissive element is disposed may be integral with a cathode of another non-emissive element disposed at a distance from the light receiving area without being separated by the separator.

The separator may surround each of the cathode of the light emitting diode and the cathode of the non-emissive element, and may have substantially reversely tapered sidewalls on opposite side surfaces.

The emissive display device may further include an additional second driving voltage line electrically connected to the cathode of the light receiving diode through a contact hole to transfer a second driving voltage.

An anode of the light emitting diode may receive a first driving voltage, and the cathode of the non-emissive element may receive a second driving voltage.

The second circuit part may include a first sensing transistor include that includes a gate electrode electrically connected to an anode of the non-emissive element, a first electrode to which a common voltage is transferred, and a second electrode; a second sensing transistor that includes a gate electrode, a first electrode electrically connected to the second electrode of the first sensing transistor, and a second electrode electrically connected to a sensing line; and a third sensing transistor that includes a gate electrode, a first electrode to which a reset voltage is applied, and a second electrode electrically connected to the anode of the non-emissive element.

The first circuit part may include a first transistor that includes a gate electrode, a first electrode, and a second electrode; a second transistor that includes a gate electrode, a first electrode electrically connected to a data line, and a second electrode electrically connected to the gate electrode of the first transistor; a fifth transistor that includes a gate electrode, a first electrode electrically connected to the cathode of the light emitting diode, and a second electrode electrically connected to the first electrode of the first transistor; and a sixth transistor that includes a gate electrode, a first electrode electrically connected to the second electrode of the first transistor, and a second electrode receiving a second driving voltage.

At least one of the first transistor, the second transistor, the fifth transistor, and the sixth transistor of the first circuit part and at least one of the first sensing transistor, the second sensing transistor, and at least one of the third sensing transistor of the second circuit part may have substantially a same stacked structure.

The emissive display device may further include a cathode connecting member that electrically connects the first electrode of the fifth transistor and the cathode of the light emitting element, the cathode connecting member may have a three-layer structure, and the cathode connecting member and the cathode of the light emitting diode may be electrically connected by a side contact.

An embodiment provides an emissive display device that may include a display unit that includes a first circuit part disposed in a display area; and a light emitting diode electrically connected to the first circuit part; and a sensing part that includes a second circuit part disposed in the display area and a non-emissive element electrically connected to the second circuit part, a cathode of the light emitting diode may be electrically connected to the first circuit part, and a cathode of the non-emissive element may be electrically connected to the second circuit part.

An anode of the light emitting diode may receive a first driving voltage, and an anode of the non-emissive element may receive a first voltage.

The second circuit part may include a first sensing transistor that includes a gate electrode electrically connected to a cathode of the non-emissive element, a first electrode to which a common voltage is transferred, and a second electrode; a second sensing transistor that includes a gate electrode, a first electrode electrically connected to the second electrode of the first sensing transistor, and a second electrode electrically connected to a sensing line; and a third sensing transistor that includes a gate electrode, a first electrode to which a second driving voltage is applied, and a second electrode electrically connected to the cathode of the non-emissive element.

The first circuit part may include a first transistor that includes a gate electrode, a first electrode, and a second electrode; a second transistor that includes a gate electrode, a first electrode electrically connected to a data line, and a second electrode electrically connected to the gate electrode of the first transistor; a fifth transistor that includes a gate electrode, a first electrode electrically connected to the cathode of the light emitting diode, and a second electrode electrically connected to the first electrode of the first transistor; and a sixth transistor that includes a gate electrode, a first electrode electrically connected to the second electrode of the first transistor, and a second electrode receiving a second driving voltage.

At least one of the first transistor, the second transistor, the fifth transistor, and the sixth transistor of the first circuit part and at least one of the first sensing transistor, the second sensing transistor, and the third sensing transistor of the second circuit part may have a same stacked structure.

The emissive display device may further include a cathode connecting member that connects the first electrode of the fifth transistor and the cathode of the light emitting element, wherein the cathode connecting member may have a three-layer structure, and the cathode connecting member and the cathode of the light emitting diode may be connected by a side contact.

The cathode of the light emitting diode and the cathode of the non-emissive element may be separated from each other by a separator.

The separator may surround each of the cathode of the light emitting diode and the cathode of the non-emissive element, and may have substantially reversely tapered sidewalls on opposite side surfaces.

According to the embodiments, in the emissive display device, the sensing unit may also be formed next to the display unit in the display area, so that a sensing operation may be performed in addition to displaying an image. According to the emissive display device of an embodiment, it is possible to apply voltages to the light emitting diode of the display unit and the non-emissive element of the sensing unit by using the separator.

At least some of the above and other features of the invention are set out in the claims.

BRIEF DESCRIPTION OF THE DRAWINGS

The above and other aspects and features of the disclosure will become more apparent by describing in detail embodiments thereof with reference to the attached drawings, in which:

FIG. 1 illustrates a schematic top plan view of an emissive display device according to an embodiment;

FIG. 2 illustrates a schematic diagram of an equivalent circuit diagram of one display unit included in an emissive display device according to an embodiment;

FIG. 3 illustrates a waveform diagram showing a signal applied to the display unit of FIG. 2;

FIG. 4 illustrates a schematic diagram of an equivalent circuit diagram of one sensing unit included in an emissive display device according to an embodiment;

FIG. 5 illustrates a waveform diagram showing a signal applied to the sensing unit of FIG. 4;

FIG. 6 schematically illustrates a planar structure of an emission area and a light receiving area according to an embodiment;

FIG. 7 illustrates a schematic cross-sectional view showing an emissive area and a light receiving area in an embodiment of FIG. 6;

FIG. 8 schematically illustrates a planar structure of an emission area and a light receiving area according to an embodiment;

FIG. 9 illustrates a schematic cross-sectional view showing an emissive area and a light receiving area in the embodiment of FIG. 8;

FIG. 10 schematically illustrates a planar structure of an emission area and a light receiving area according to an embodiment;

FIG. 11 illustrates a schematic cross-sectional view showing an emissive area and a light receiving area in the embodiment of FIG. 10;

FIG. 12 illustrates a schematic diagram of an equivalent circuit diagram of one sensing unit included in an emissive display device according to an embodiment;

FIG. 13 schematically illustrates a planar structure of an emission area and a light receiving area according to an embodiment;

FIG. 14 illustrates a schematic cross-sectional view showing an emissive area and a light receiving area in the embodiment of FIG. 13;

DETAILED DESCRIPTION OF THE EMBODIMENTS

The disclosure will be described more fully hereinafter with reference to the accompanying drawings, in which embodiments are shown. As those skilled in the art would realize, the described embodiments may be modified in various different ways, all without departing from the scope of the disclosure.

To clearly describe the disclosure, parts that may be irrelevant to the description may be omitted, and like numerals refer to like or similar elements throughout the specification.

Further, since sizes and thicknesses of members shown in the accompanying drawings are arbitrarily given for better understanding and ease of description, the disclosure is not limited to the illustrated sizes and thicknesses. In the drawings, the thicknesses of layers, films, panels, regions, etc., are exaggerated for clarity. In the drawings, for better understanding and ease of description, the thicknesses of some layers and areas are exaggerated.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or. "

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

It will be understood that when an element such as a layer, film, region, plate, constitute elements, etc. is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

Further, throughout the specification, the phrase "in a plan view" means when an object portion is viewed from above, and the phrase "in a cross-sectional view" means when a crosssection taken by vertically cutting an object portion is viewed from the side.

In the specification, "connected" means that two or more components are not only directly connected, but two or more components may be connected indirectly through other components, physically connected as well as being electrically connected, or it may be referred to by different names depending on the location or function, but may include connecting each of parts that are substantially integral to each other.

Throughout the specification, when it is said that a portion of a wire, layer, film, region, plate, component, etc., "extends in a first direction or a second direction," this does not indicate only a straight shape extending straight in the corresponding direction, and indicates a structure that generally extends along the first direction or the second direction, and it may include a structure that is bent at a portion, has a zigzag structure, or extends while including a curved structure.

An electronic device (for example, a mobile phone, TV, monitor, notebook computer, etc.) including a display device, a display panel, etc. described in the specification, or an electronic device including a display device and a display panel manufactured by the manufacturing method described in the specification, are not excluded from the scope of the specification.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

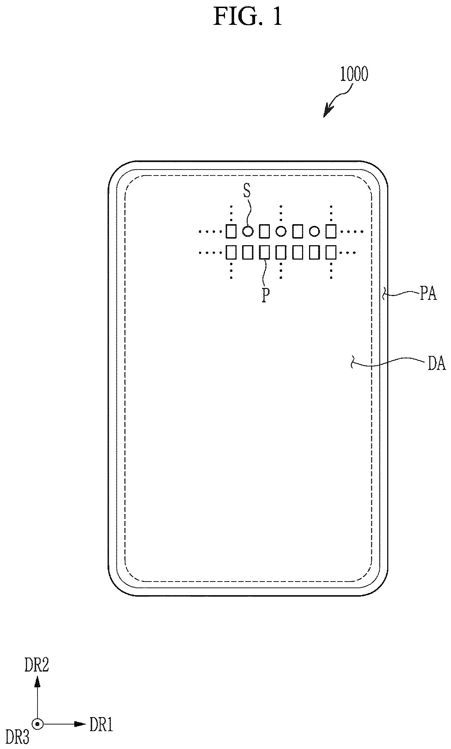

Hereinafter, a schematic structure of the entire emissive display device will be described through FIG. 1.

FIG. 1 illustrates a schematic top plan view of an emissive display device according to an embodiment.

The emissive display device 1000 according to the embodiment of FIG. 1 may include of display units P and sensing units S in the display area DA.

Referring to FIG. 1, the emission display device 1000 according to an embodiment may include a display area DA in which the display units P are positioned to display images, and a non-display area PA adjacent to the display area DA. The non-display area PA is an area in which an image is not displayed. Each of the display units P may correspond to a pixel, and the sensing units S are positioned adjacent to the display units P in the display area DA of FIG. 1.

The sensing units S are portions for sensing incident light reflected from an external object (for example, a user finger or fingerprint) positioned in the third direction DR3 of the emissive display device 1000. A number of sensing units S positioned in the display area DA may be smaller than the number of display units P, and the sensing units S may be positioned only in some or a number of regions of the display area DA.

In FIG. 1, the display unit P is illustrated in a quadrangular shape and the sensing unit S is illustrated in an elliptical shape, but this may not be an actual plane shape, and it is illustrated using a quadrangle and an ellipse in order to readily distinguish them from each other, however, the disclosure is not limited thereto.

The non-display area PA may surround the display area DA. The non-display area PA is an area in which an image is not displayed, and may be positioned at an outer portion of the emissive display device 1000.

At least a portion of the emissive display device 1000 according to an embodiment may be a flexible display device including a bending portion that is bent. For example, a center of the emissive display device 1000 may be flat, and an edge portion thereof may have a bent shape.

In the emissive display device 1000, a first surface on which an image is displayed is parallel to a surface defined by a first direction DR1 and a second direction DR2. A direction normal to a surface on which an image is displayed, for example, a thickness direction of the emissive display device 1000, is represented as a third direction DR3. A front (or top) surface and a back (or bottom) surface of each of the members are separated in the third direction DR3. However, the directions indicated by the first to third directions DR1, DR2, and DR3 may be converted to other directions within the scope of the disclosure.

The emissive display device 1000 may further include a touch unit and/or a cover window at an upper side.

The emissive display device 1000 according to an embodiment may include an organic or inorganic emission layer, and may also include a color conversion layer including quantum dots and/or a color filter.

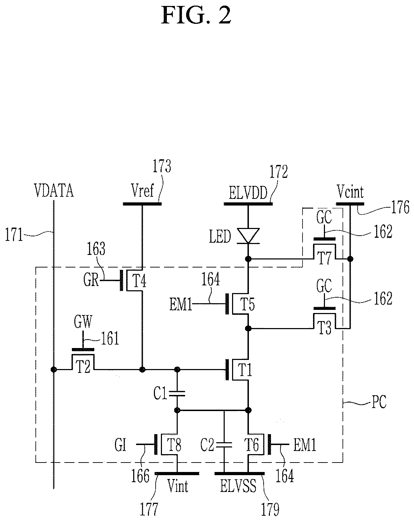

Hereinafter, a circuit structure of the display units P and the sensing units S positioned in the display area DA will be described through FIG. 2 to FIG. 5.

The circuit structure of the display units positioned in the display area is as follows through the embodiment of FIG. 2.

FIG. 2 illustrates a schematic diagram of an equivalent circuit diagram of one display unit included in an emissive display device according to an embodiment.

Referring to FIG. 2, one display unit may include a light emitting diode LED and a first circuit part PC (hereinafter referred to as a pixel circuit unit) driving the light emitting device LED, and the first circuit part PC is arranged or disposed in a matrix form. The first circuit part PC may include all other elements except for the light emitting diode LED in FIG. 2, and the first circuit part PC of the display unit according to the embodiment of FIG. 2 may include a first transistor T1, a second transistor T2, a third transistor T3, a fourth transistor T4, a fifth transistor T5, a sixth transistor T6, a seventh transistor T7, an eighth transistor T8, a first capacitor C1, and a second capacitor C2.

The first circuit part PC may be connected to a first scan line 161 to which a first scan signal GW is applied, a second scan line 162 to which a second scan signal GC is applied, a third scan line 163 to which a third scan signal GR is applied, a fourth scan line 166 to which a fourth scan signal GI is applied, a first emission signal line 164 to which a first emission signal EM1 is applied, and a data line 171 to which a data voltage VDATA is applied. The display unit may be connected to a first driving voltage line 172 to which a driving voltage ELVDD (hereinafter referred to as a first driving voltage) is applied, a second driving voltage line 179 to which a driving low voltage ELVSS (hereinafter referred to as a second driving voltage) is applied, a reference voltage line 173 to which a reference voltage Vref is applied, a first initialization voltage line 177 to which a first initialization voltage Vint is applied, and a second initialization voltage line 176 to which a second initialization voltage Vcint is applied.

A circuit structure of the display unit will be as follows, focusing on each element (a transistor, a capacitor, a light emitting diode) included in the display unit.

The first transistor T1 (hereinafter also referred to as a driving transistor) may include a gate electrode connected to a first electrode of the first capacitor C1, a second electrode of the second transistor T2, and a second electrode of the fourth transistor T4, a first electrode (input-side electrode) connected to a second electrode of the third transistor T3 and a second electrode of the fifth transistor T5, and a second electrode (output-side electrode) connected to a first electrode of the sixth transistor T6, a second electrode of the eighth transistor T8, a second electrode of the first capacitor C1, and a second electrode of the second capacitor C2.

A degree to which the first transistor T1 is turned on is determined depending on a voltage of the gate electrode of the first transistor T1, and an amount of current flowing from the first electrode to the second electrode of the first transistor T1 is determined depending on a degree of turn-on. A current flowing from the first electrode to the second electrode of the first transistor T1 is equal to a current flowing through the light emitting diode LED during an emission period, and may be referred to as an emission current. Herein, the first transistor T1 is formed as an n-type transistor, and as a voltage of the gate electrode increases, a large emission current may flow. In case that the emission current is large, the light emitting diode LED can display high luminance.

The second transistor T2 (hereafter also referred to as a data input transistor) may include a gate electrode connected to the first scan line 161 to which the first scan signal GW is applied, a first electrode (input-side electrode) connected to the data line 171 to which the data voltage VDATA is applied, and a second electrode (output-side electrode) connected to the first electrode of the first capacitor C1, the gate electrode of the first transistor T1, and the second electrode of the fourth transistor T4. The second transistor T2 may input the data voltage VDATA into the display unit depending on the first scan signal GW to transfer the data voltage VDATA to the gate electrode of the first transistor T1, and may allow the data voltage VDATA to be stored in the first electrode of the first capacitor C1.

The third transistor T3 (hereinafter also referred to as a first voltage transfer transistor) may include a gate electrode connected to the second scan line 162 to which the second scan signal GC is applied, a first electrode (input-side electrode) connected to the second initialization voltage line 176 to which the second initialization voltage Vcint is applied, and a second electrode (output-side electrode) connected to the first electrode of the first transistor T1 and the second electrode of the fifth transistor T5. The third transistor T3 allows the second initialization voltage Vcint to be transmitted to the first transistor T1 without passing through the light emitting diode LED. Herein, the second initialization voltage Vcint may have a positive voltage value similar to the first driving voltage ELVDD. According to an embodiment, the first driving voltage ELVDD or the bias voltage Vbais may be applied instead of the second initialization voltage Vcint. In case that a current flows through the light emitting diode LED, a problem may occur in which the light emitting diode LED emits light unnecessarily, and thus the third transistor T3 may transfer the second initialization voltage Vcint to the first transistor T1 through a separate path. Therefore, the third transistor T3 may not be turned on during the emission period and may be turned on during other periods.

The fourth transistor T4 (hereinafter also referred to as a reference voltage transfer transistor) may include a gate electrode connected to the third scan line 163 to which the third scan signal GR is applied, a first electrode connected to the reference voltage line 173 and the first electrode of the first capacitor C1, and a second electrode connected to the gate electrode of the first transistor T1 and the second electrode of the second transistor T2. The fourth transistor T4 serves to perform initialization by transferring the reference voltage Vref to the first electrode of the first capacitor C1 and the gate electrode of the first transistor T1.

The fifth transistor T5 (hereinafter referred to as a cathode-connected transistor) may include a gate electrode connected to the first emission signal line 164 to which the first emission signal EM1 is applied, a first electrode connected to a cathode of the light emitting diode LED and the second electrode of the seventh transistor T7, and a second electrode connected to the first electrode of the first transistor T1 and the second electrode of the third transistor T3. The fifth transistor T5 connects the first electrode of the first transistor T1 and the light emitting diode LED based on the first emission signal EM1 to form a current path, and allows the light emitting diode LED to emit light.

The sixth transistor T6 (hereinafter also referred to as a driving low voltage applying transistor) may include a gate electrode connected to the first emission signal line 164 to which the first emission signal EM1 is applied, a first electrode connected to the second electrode of the first transistor T1, the second electrode of the eighth transistor T8, the second electrode of the first capacitor C1, and the first electrode connected to the second electrode of the second capacitor C2, and a second electrode receiving the second driving voltage ELVSS. The sixth transistor T6 serves to transmit the second driving voltage ELVSS to the second electrode of the first transistor T1 based on the first emission signal EM1, or to block it.

The seventh transistor T7 (hereinafter also referred to as a second voltage transfer transistor or a second initialization voltage transfer transistor) may include a gate electrode connected to the second scan line 162 to which the second scan signal GC is applied, a first electrode (input-side electrode) connected to the second initialization voltage line 176, and a second electrode (output-side electrode) connected to the cathode of the light emitting diode LED and the first electrode of the fifth transistor T5. The seventh transistor T7 serves to transfer the second initialization voltage Vcint to the cathode, and changes a voltage level of the cathode to the second initialization voltage Vcint, thereby eliminating a problem of not displaying black due to charges remaining on the cathode and enabling clear display of black. Herein, the second initialization voltage Vcint may have a positive voltage value similar to the first driving voltage ELVDD. According to an embodiment, the first driving voltage ELVDD or the bias voltage Vbais may be applied instead of the second initialization voltage Vcint.

The eighth transistor T8 (hereinafter also referred to as a first initialization voltage transfer transistor) may include a gate electrode connected to the fourth scan line 166 to which the fourth scan signal GI is applied, a first electrode (input-side electrode) connected to the first initialization voltage line 177, and a second electrode (output side electrode) connected to the second electrode of the first transistor T1, the first electrode of the sixth transistor T6, the second electrode of the first capacitor C1, and the second electrode of the second capacitor C2. The eighth transistor T8 serves to apply the first initialization voltage Vint to the second electrode of the first transistor T1, the first electrode of the sixth transistor T6, the second electrode of the first capacitor C1, and the second electrode of the second capacitor C2 to initialize it.

In the embodiment of FIG. 2, all transistors are n-type transistors, and each transistor may be turned on in case that a voltage of the gate electrode is at a high level and turned off in case that the voltage of the gate electrode is at a low level. For the semiconductor layer included in each of the transistors, a polycrystalline silicon semiconductor or an oxide semiconductor may be used, and an amorphous semiconductor or a single crystal semiconductor may be additionally used.

According to an embodiment, the semiconductor layer included in each transistor may further include an overlapping layer (or an additional gate electrode) overlapping it, and display quality of the display unit may be further improved by applying a voltage to the overlapping layer (additional gate electrode) to change characteristics of the transistors.

The first capacitor C1 may include a first electrode connected to the gate electrode of the first transistor T1, the second electrode of the second transistor T2, and the second electrode of the fourth transistor T4, and a second electrode connected to the second electrode of the first transistor T1, the first electrode of the sixth transistor T6, the second electrode of the eighth transistor T8, and the second electrode of the second capacitor C2. The first electrode of the first capacitor C1 serves to receive the data voltage VDATA from the second transistor T2 to store it.

The second capacitor C2 may include a first electrode connected to the second driving voltage line 179, the second electrode of the first transistor T1, and the first electrode of the sixth transistor T6, and a second electrode connected to the second electrode of the eighth transistor T8 and the second electrode of the first capacitor C1. The second capacitor C2 serves to constantly maintain voltages of the second electrode of the first transistor T1 and the second electrode of the first capacitor C1. According to an embodiment, the first electrode of the second capacitor C2 may be connected to the first driving voltage line 172, or the second capacitor C2 may be omitted.

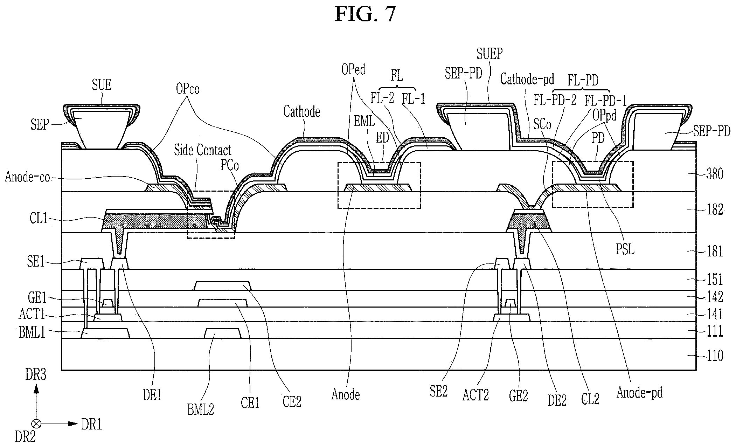

The light emitting diode LED has an anode connected to the first driving voltage line 172 and receiving the first driving voltage ELVDD, and a cathode connected to the first electrode of the fifth transistor T5 and the second electrode of the seventh transistor T7. A cathode of the light emitting diode LED is connected to the first transistor T1 through the fifth transistor T5. The light emitting diode LED may be positioned between the first circuit part PC and the first driving voltage ELVDD to allow a same current as the current flowing through the first transistor T1 of the first circuit part PC to flow, and luminance of light emission may also be determined depending on a magnitude of the corresponding current. The light emitting diode LED may include an emission layer including at least one of an organic light emitting material or an inorganic light emitting material between the anode and the cathode. An example stacked structure of the light emitting diode LED according to an embodiment may be the same as that of FIG. 7.

The display unit according to the embodiment of FIG. 2 may perform a compensation operation for detecting a change in a characteristic (threshold voltage) of the first transistor T1, to display constant display luminance regardless of a change in the characteristic of the first transistor T1.

In FIG. 2, opposite electrodes of the light emitting diode LED are connected to the first electrode of the first transistor T1 and the first driving voltage line 172. The display unit according to an embodiment is distinguished from a display unit in which opposite electrodes of the light emitting diode are connected to the second electrode of the first transistor T1 and the second driving voltage line 179 to which the second driving voltage ELVSS is applied, which is referred to as "an inverted structure."

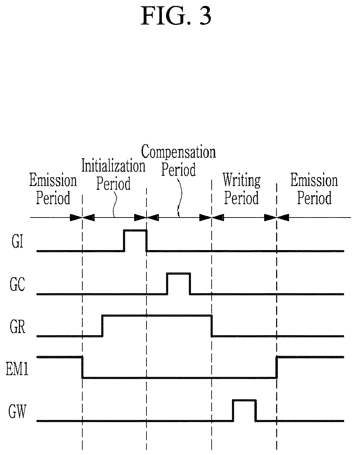

The light emitting diode exhibits luminance depending on a magnitude of a current flowing in a current path from the first driving voltage ELVDD to the second driving voltage ELVSS through the first transistor T1, and as the current increases, the displayed luminance may also be increased. In the structure of FIG. 2, the first electrode of the first transistor T1 and the light emitting diode LED are connected and separated from the second electrode (source electrode) of the first transistor T1, and thus in case that the voltage of each portion of the first circuit part PC is changed, a voltage of the second electrode (source electrode) of the first transistor T1 may not vary. By way of example, in case that the sixth transistor T6 is turned on, as a voltage of the second electrode of the first capacitor C1 decreases, a voltage of the first electrode of the first capacitor C1 also decreases, and as a result, the output current output by the first transistor T1 may also be lowered, but in an embodiment, a problem that an output current of the first transistor T1 is lowered is eliminated. This will be described in detail while describing an operation of FIG. 3.

In the embodiment of FIG. 2, it has been described that one display unit P may include the eight transistors T1 to T8 and the two capacitors (the first capacitor C1 and the second capacitor C2), but the disclosure is not limited thereto, and according to an embodiment, additional capacitors or transistors may be further included, or some or a number of capacitors or transistors may be omitted.

In the above, a circuit structure of a display unit according to an embodiment has been described with reference to FIG. 2.

Hereinafter, a waveform of the signal applied to the display unit of FIG. 2 and a corresponding operation of the display unit will be described in detail through FIG. 3.

FIG. 3 illustrates a waveform diagram showing a signal applied to the display unit of FIG. 2.

Referring to FIG. 3, in case that a signal applied to the display unit is divided into periods, it is divided into an initialization period, a compensation period, a writing period, and an emission period.

The emission period is a period during which the light emitting diode LED emits light, and a gate-on voltage (high level voltage) is applied to the first emission signal EM1 to turn on the fifth transistor T5 and the sixth transistor T6. A gate-off voltage (low level voltage) is applied to the first scan signal GW, the second scan signal GC, the third scan signal GR, and the fourth scan signal GI. As a result, a current path connected the first driving voltage ELVDD to the second driving voltage ELVSS through the light emitting diode LED, the fifth transistor T5, the first transistor T1, and the sixth transistor T6 is formed. A magnitude of the current flowing through the current path is determined depending on a degree to which a channel of the first transistor T1 is turned on, and a degree to which the channel of the first transistor T1 is turned on is determined depending on a voltage of the gate electrode of the first transistor T1 (or the first electrode of the first capacitor C1). Accordingly, as an output current generated depending on a voltage of the gate electrode of the first transistor T1 flows along the current path including a light emitting diode LED, the light emitting diode LED emits light. In FIG. 3, the emission period during which the emission signal applies a gate-on voltage is hardly illustrated, but in reality, the emission period has a longest time. However, the emission period is simply illustrated in FIG. 3 because only the above simple operation is performed.

As the first emission signal EM1 is changed to a gate-off voltage (low level voltage), the emission period ends and the initialization period is entered.

Referring to FIG. 3, during the initialization period, the third scan signal GR is first changed to a gate-on voltage (high level voltage) and the fourth scan signal GI is changed to a gate-on voltage (high level voltage). A gate-off voltage (low level voltage) is applied to the first scan signal GW, the second scan signal GC, and the first emission signal EM1.

The fourth transistor T4 connected to the third scan signal GR applied after being changed to a gate-on voltage (high level voltage) is turned on so that the reference voltage Vref is transferred to the gate electrode of the first transistor T1 and the first electrode of the first capacitor C1 to be initialized. Herein, the reference voltage Vref may have a voltage value capable of turning on the first transistor T1.

Thereafter, the fourth scan signal GI is also applied while being changed to a gate-on voltage (high level voltage), so that the eighth transistor T8 is also turned on, and as a result, the second electrode of the first transistor T1, the first electrode of the sixth transistor T6, the second electrode of the first capacitor C1, and the second electrode of the second capacitor C2 are initialized to the first initialization voltage Vint.

Thereafter, as the fourth scan signal GI is changed to a gate-off voltage (low level voltage), the initialization period ends and the compensation period is entered.

Referring to FIG. 3, during the compensation period, while the third scan signal GR maintains the gate-on voltage (high level voltage), the second scan signal GC is changed to the gate-on voltage (high level voltage). A gate-off voltage (low level voltage) is applied to the first scan signal GW, the fourth scan signal GI, and the first emission signal EM1.

While the reference voltage Vref continues to be transferred to the gate electrode of the first transistor T1 and the first electrode of the first capacitor C1 through the turned-on fourth transistor T4, the third transistor T3 and the seventh transistor T7 are also turned on by the second scan signal GC of the additionally applied gate-on voltage (high level voltage), and the second initialization voltage Vcint is transmitted to the first electrode of the first transistor T1 and the cathode of the light emitting diode LED. The first transistor T1 is turned on by the reference voltage Vref, and thus a value of Vgs of the first transistor is equal to a value of the threshold voltage Vth of the first transistor T1. Herein, the Vgs is a value obtained by subtracting a voltage of the second electrode (source electrode) of the first transistor T1 from a voltage of the gate electrode, and thus a voltage value of the second electrode (source electrode) of the first transistor T1 has a voltage value (Vref-Vth) that is lower than the voltage of the gate electrode by the threshold voltage Vth of the first transistor T1. The turned-on seventh transistor T7 changes a voltage level of the cathode to the second initialization voltage Vcint to initialize the voltage of the cathode to the second initialization voltage Vcint, and a problem of not displaying black is eliminated by removing charges remaining on the cathode.

Thereafter, referring to FIG. 3, the second scan signal GC is changed to the gate-off voltage (voltage at a low level), and the third scan signal GR also changes to the gate-off voltage (low level voltage) and enters the writing period.

During the writing period, the gate-on voltage (the high level voltage) is applied to the first scan signal GW. The period during which the first scan signal GW is maintained at the gate-on voltage may be 1H. 1H represents 1 horizontal period, and 1 horizontal period may correspond to one horizontal synchronization signal Hsync. 1H may indicate a time for which a gate-on voltage is applied to a scan line of a next row after the gate-on voltage is applied to a scan line. During the writing period, the gate-off voltage (low level voltage) is applied to the second scan signal GC, the third scan signal GR, the fourth scan signal GI, and the first emission signal EM1.

During the writing period, the second transistor T2 to which the gate-on voltage (high level voltage) is applied is turned on, and all other transistors are turned off. As a result, the data voltage VDATA enters the display unit and is applied to the gate electrode of the first transistor T1 and the first electrode of the first capacitor C1. The voltage value of the second electrode of the first transistor T1 has a voltage value (Vref-Vth) that is lower than the voltage of the gate electrode by the threshold voltage Vth of the first transistor T1, like during the compensation period.

The third transistor T3 and the fifth transistor T5 are turned off, so that the first electrode of the first transistor T1, the first driving voltage line 172, and the light emitting diode LED are electrically separated from each other.

Thereafter, referring to FIG. 3, the first emission signal EM1 is changed to the gate-on voltage (high level voltage) and enters the emission period. The gate-off voltage (low level voltage) is applied to the first scan signal GW, the second scan signal GC, the third scan signal GR, and the fourth scan signal GI.

The fifth transistor T5 and the sixth transistor T6 are turned on by the first emission signal EM1, and a current path connecting the first driving voltage ELVDD to the second driving voltage ELVSS through the light emitting diode LED, the fifth transistor T5, the first transistor T1, and the sixth transistor T6 is formed. A magnitude of the current flowing along the current path is determined depending on a degree to which the first transistor T1 is turned on, and a degree to which the first transistor T1 is turned on is determined depending on a magnitude of the data voltage VDATA applied to the gate electrode. The light emitting diode LED displays brightness differently depending on a magnitude of a current flowing along the current path $I_{OLED}$.

As it enters the emission period, the sixth transistor T6 is turned on, and as a result, voltages of the second electrode of the first capacitor C1 and the second electrode of the first transistor T1 are changed to the second driving voltage ELVSS. In case that the voltage value of the second electrode of the first capacitor C1 is changed, the voltage value of the first electrode of the first capacitor C1 is also changed accordingly. Herein, a voltage variation value of the first electrode of the first capacitor C1 may be equal to the voltage value of the second electrode of the first capacitor C1.

During the writing period, the voltage values of the second electrode of the first transistor T1 and the second electrode of the first capacitor C1 is a value (Vref-Vth) obtained by subtracting the threshold voltage Vth of the first transistor T1 from the reference voltage Vref, and thus, as the writing period is changed to the emission period, a voltage variation value of the second electrode of the first capacitor C1 and a voltage variation value ΔV of the first electrode of the first capacitor C1 are expressed as in Equation 1 below.

[Equation 1]

$$\Delta V = V_{ELVSS} - (V_{ref} - V_{th})$$

Herein, $V_{ref}$ indicates the voltage value of the reference voltage Vref, $V_{th}$ indicates the threshold voltage value of the first transistor T1, and $V_{ELVSS}$ indicates the voltage value of the second driving voltage ELVSS.

The current $I_{OLED}$ flowing through the light emitting diode LED during the light emitting period may be obtained by Equation 2 below.

[Equation 2]

$$I_{OLED} = k/2 \; x \; (Vgs - V_{th})^2$$
$$= k/2 \; x \; [(V_{data} + \Delta V - V_{ELVSS}) - V_{th}]^2$$
$$= k/2 \; x \; [(V_{data} + (V_{ELVSS} - V_{ref} + V_{th}) - V_{ELVSS}) - V_{th}]^2$$
$$= k/2 \; x \; (V_{data} - V_{ref})^2$$

Herein, k indicates a constant value, $V_{data}$ indicates the voltage value of the data voltage, $V_{ref}$ indicates the voltage value of the reference voltage Vref, $V_{th}$ indicates the threshold voltage value of the first transistor T1, $V_{ELVSS}$ indicates a voltage value of the second driving voltage ELVSS, Vgs indicates the voltage difference between the gate electrode and the second electrode of the first transistor T1, and ΔV is the value of Equation 1.

Accordingly, the value of the current $I_{OLED}$ flowing through the light emitting diode LED is determined only by the value of the data voltage VDATA and the value of the reference voltage Vref, and since it has a value independent of the threshold voltage Vth of the first transistor T1, it has the advantage of being able to generate a constant output current $I_{OLED}$ despite the change in the characteristics of the first transistor T1.

Since the voltage variation value ΔV generated at the gate electrode while the second driving voltage ELVSS is applied during the emission period is also removed as in Equation 1, there is no need to consider it separately, and since only the data voltage VDATA value and the reference voltage Vref need to be considered, the current does not change depending on the characteristics of the first transistor T1.

In the above, the voltage value of the first driving voltage ELVDD may be set higher than a value obtained by subtracting the threshold voltage value of the first transistor T1 from the voltage value of the reference voltage Vref, and the voltage value of the second driving voltage ELVSS may be set to be smaller than a value obtained by subtracting the threshold voltage value of the first transistor T1 from the voltage value of the reference voltage Vref.

In the above, the operation depending on the display unit of FIG. 2 and the waveform of FIG. 3 has been described.

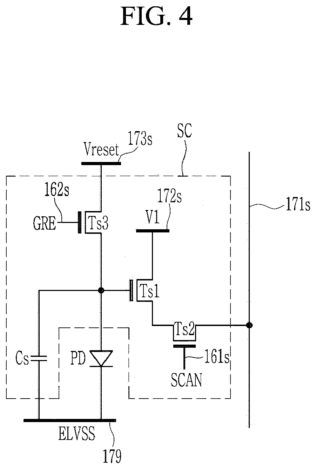

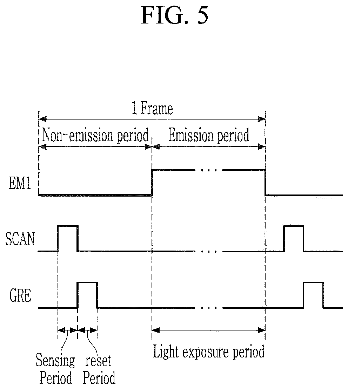

Hereinafter, the sensing unit located or disposed in the display area will be described through FIG. 4 and FIG. 5.

A circuit structure of the sensing unit will be described through FIG. 4.

FIG. 4 illustrates a schematic diagram of an equivalent circuit diagram of one sensing unit included in an emissive display device according to an embodiment.

The sensing unit may include a non-emissive element PD (hereinafter also referred to as a photodiode) and a second circuit part SC (hereinafter also referred to as a light sensing circuit). The non-emissive element PD may be an organic photodiode, and other parts of the sensing unit excluding the non-emissive element may constitute the second circuit part SC.

In the embodiment of FIG. 4, the second circuit part SC of the sensing unit may include three sensing transistors Ts1, Ts2, and Ts3 and one capacitor Cs (hereinafter referred to as a sensing capacitor). However, according to an embodiment, the sensing capacitor Cs may not be included.

The sensing unit may be connected to a first sensing scan line 161s to which a sensing scan signal SCAN is applied, a second sensing scan line 162s to which a sensing reset signal GRE is applied, and a sensing line 171s for reading out a current or a voltage. The sensing unit may be connected to a first power voltage line 172s to which a first power voltage V1 (hereinafter referred to as a common voltage) is applied, a reset voltage line 173s to which the reset voltage Vreset is applied, and a second driving voltage line 179 to which a driving low voltage (ELVSS; hereinafter referred to as a second driving voltage) is applied.

The circuit structure of the sensing unit will be as follows, focusing on each element (a transistor, a capacitor, a non-emissive element) included in the sensing unit.

The first sensing transistor Ts1 (hereinafter referred to as an amplification transistor) may include a gate electrode connected to an anode of the non-emissive element PD, a second electrode of the sensing capacitor Cs, and a second electrode of the third sensing transistor Ts3, a first electrode (input-side electrode) connected to the first power voltage line 172s to which the first power voltage V1 is applied, and a second electrode (output-side electrode) connected to a first electrode of the second sensing transistor Ts2. Herein, the first power voltage V1 may be applied to first electrodes of the first sensing transistors Ts1 of all sensing units positioned in the display area. The first sensing transistor Ts1 serves to transfer an output amplified depending on an anode voltage of the non-emissive element PD to the second sensing transistor Ts2.

The second sensing transistor Ts2 (hereinafter also referred to as an output transistor) may include a gate electrode connected to the first sensing scan line 161s to which a sensing scan signal SCAN is applied, a first electrode (input-side electrode) connected to the second electrode of the first sensing transistor Ts1, and a second electrode (output side electrode) connected to the sensing line 171s. The second sensing transistor Ts2 serves to output the amplified output of the first sensing transistor Ts1 to the sensing line 171s to sense it.

The third sensing transistor Ts3 (hereinafter also referred to as a reset transistor) may include a gate electrode connected to the second sensing scan line 162s to which the sensing reset signal GRE is applied, a first electrode (input-side electrode) connected to the reset voltage line 173s to which the reset voltage Vreset is applied, and a second electrode (output-side electrode) connected to the gate electrode of the first sensing transistor Ts1, the anode of the non-emissive element PD, and the second electrode of the sensing capacitor Cs. The third sensing transistor Ts3 serves to reset the anode voltage of the non-emissive element PD to the reset voltage Vreset.

In an embodiment, the three sensing transistors Ts1, Ts2, and Ts3 are formed of n-type transistors, and each transistor may be turned on in case that a voltage of the gate electrode is at a high level and turned off in case that the voltage of the gate electrode is at a low level. For the semiconductor layer included in each of the transistors, a polycrystalline silicon semiconductor or an oxide semiconductor may be used, and an amorphous semiconductor or a single crystal semiconductor may be additionally used.

The sensing capacitor Cs may include a first electrode connected to the second driving voltage line 179, and a second electrode connected to the gate electrode of the first sensing transistor Ts1, the anode of the non-emissive element PD, and the second electrode of the third sensing transistor Ts3. The sensing capacitor Cs serves to constantly maintain a voltage of the gate electrode of the first sensing transistor Ts1 and a voltage of the anode of the non-emissive element PD. According to an embodiment, the first electrode of the sensing capacitor Cs may be connected to a voltage line other than the second driving voltage line 179, or the sensing capacitor Cs may be omitted.

The non-emissive element PD may include an anode connected to the gate electrode of the first sensing transistor Ts1, the second electrode of the third sensing transistor Ts3, and the second electrode of the sensing capacitor Cs, and a cathode connected to the second driving voltage line 179. The non-emissive element PD may change voltage values of the gate electrode of the first sensing transistor Ts1 and the second electrode of the sensing capacitor Cs by generating or reducing photocharges based on the intensity of external light.

The second circuit part SC illustrated in FIG. 4 is an example, and a configuration of the second circuit part SC may be modified.

Hereinafter, an operation of the sensing unit based on the signal of FIG. 5 applied to the sensing unit of FIG. 4 will be described.

FIG. 5 illustrates a waveform diagram showing a signal applied to the sensing unit of FIG. 4.

In FIG. 5, the first emission signal EM1 applied to the display unit is also illustrated, and an emission period and a non-emission period are separated based on the first emission signal EM1. Herein, the initialization period, the compensation period, and the writing period described in FIG. 3 may be positioned in the non-emission period.

Referring to FIG. 5, during the non-emission period, the sensing scan signal SCAN and the sensing reset signal GRE are sequentially applied to the sensing unit, and during the light-emission period in which the display unit emits light, the non-emissive element PD of the sensing unit proceeds to a light exposure period in which it is exposed to light incident after being reflected from an external object (for example, a fingerprint of a finger, which is one of user authentication means). Herein, the emission period of the display unit and the light exposure period of the sensing unit may have a same starting point and end point.

The operation of the sensing unit will be described below in an order of the light exposure period, the sensing period, and the reset period.

During the light exposure period, the light emitting element of the display unit emits light, and light emitted from the display unit is reflected by an external object (for example, a fingerprint of a finger) and transferred to the non-emissive element PD of the sensing unit. In case that the externally reflected light is transmitted to the non-emissive element PD, the non-emissive element PD may change voltage values of the gate electrode of the first sensing transistor Ts1 and the second electrode of the sensing capacitor Cs from an existing voltage (reset voltage Vreset) value by generating or reducing photocharges based on the intensity of external light. In case that the light exposure period ends, the light receiving device PD no longer generates or reduces photocharges, and thus voltage values of the gate electrode of the first sensing transistor Ts1 and the second electrode of the sensing capacitor Cs are maintained without being changed any more.

Thereafter, the sensing scan signal SCAN is changed to a high voltage and the sensing period is entered.

The second sensing transistor Ts2 is turned on by the sensing scan signal SCAN, and an amplified output of the first sensing transistor Ts1 is outputted to the sensing line 171s. Herein, the amplified output of the first sensing transistor Ts1 is determined depending on a voltage of the gate electrode of the first sensing transistor Ts1, for example, an anode voltage of the non-emissive element PD. The anode voltage of the non-emissive element PD is changed depending on a magnitude of the light transferred to the non-emissive element PD during the light exposure period. Accordingly, the value output from the second sensing transistor Ts2 has a value corresponding to the magnitude of light transferred to the non-emissive element PD during the light exposure period.

After the sensing scan signal SCAN changes to a low voltage, the reset period is entered while the sensing reset signal GRE changes to a high voltage.

The third sensing transistor Ts3 is turned on by the sensing reset signal GRE, and voltages of the gate electrode of the first sensing transistor Ts1, the anode of the light receiving element PD, and the second electrode of the sensing capacitor Cs are reset to the reset voltage Vreset.

Thereafter, in case that the light exposure period is entered again, a voltage of the anode of the non-emissive element PD that is reset to the reset voltage Vreset while external light is transferred to the non-emissive element PD is changed.

In the above, signals applied to the display unit and the sensing unit positioned in the display area have been described independently of each other, but some signals may be applied at the same timing. For example, the sensing scan signal SCAN or sensing reset signal GRE applied to the sensing unit may be applied at the same timing as one of the first scan signal GW, the second scan signal GC, the third scan signal GR, and the fourth scan signal GI applied to the display unit.

As such, in case that the display area may include both the display unit and the sensing unit, the display area may be widened by reducing the non-display area positioned outside the display area.

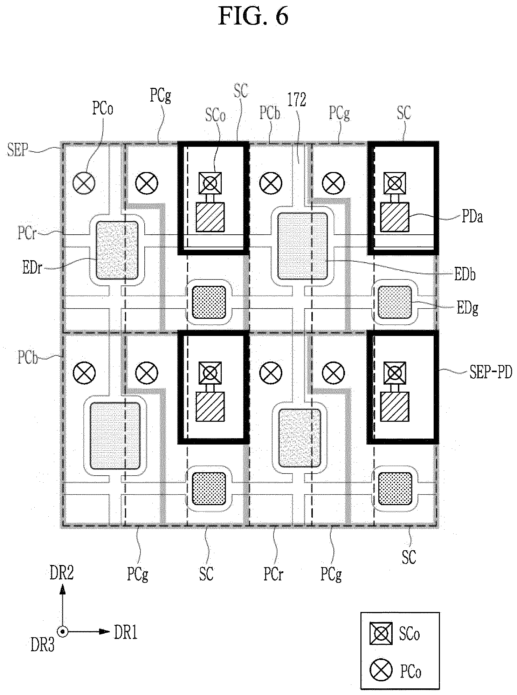

In the above, the circuit structure and operation of the display unit and the sensing unit positioned in the display area according to an embodiment have been described. Hereinafter, the structure of the display unit including the light emitting diode and the sensing unit including the non-emissive element according to each embodiment will be described through FIG. 6 to FIG. 11.

In the display area of the emissive display device, the display unit including the light emitting diode described above and the sensing unit including the non-emissive element are positioned, the light emitting diode corresponds to an emission area corresponding to an opening OPed of the pixel defining layer 380 (see FIG. 7), and the non-emissive element may correspond to a light receiving area corresponding to an opening OPpd of the pixel defining layer 380. Hereinafter, a following description will be made based on an emission area or a light receiving area, or the openings Oped and OPpd of the pixel defining layer 380 instead of a light emitting diode and a non-emissive element.

A planar structure of a display unit including a light emitting area and a sensing unit including a light receiving area according to an embodiment will be described through FIG. 6.

FIG. 6 schematically illustrates a planar structure of an emission area and a light receiving area according to an embodiment.

FIG. 6 illustrates a portion of the display area DA, and as illustrated in FIG. 6, emission areas EDr, EDg, and EDb corresponding to light emitting diodes included in the display unit and light receiving areas PDa corresponding to the non-emissive elements PD included in first circuit parts PCr, PCg, and PCb and a sensing unit, and the second circuit part SC, are positioned.

In the embodiment of FIG. 6, a total of 12 first circuit parts PCr, PCg, and PCb and second circuit parts SC adjacent to each other are schematically illustrated by dotted lines. In FIG. 6, in a first column, a red first circuit part PCr and a blue first circuit part PCb are alternately positioned in that order, in a second column, the green first circuit part PCg is continuously positioned, in a third column, the second circuit part SC is continuously positioned, in a fourth column, a blue first circuit part PCb and a red first circuit part PCr are alternately positioned in that order, in the fifth column, a first green circuit unit PCg is continuously positioned, and in the sixth column, the second circuit part SC is continuously positioned. A number and disposition of the first circuit parts PCr, PCg, and PCb and the second circuit parts SC may be variously changed.

On the first circuit parts PCr, PCg, and PCb and the second circuit parts SC, the emission areas EDr, EDg, and EDb and the light receiving area PDa respectively connected thereto are positioned.

The first circuit parts PCr, PCg, and PCb are electrically connected to cathodes positioned in the emission areas EDr, EDg, and EDb through contact holes PCo, and cathodes positioned in the respective emission areas EDr, EDg, and EDb are electrically separated by a separator SEP. Herein, the separator SEP may be a symmetrical separator, and the separator SEP may have a symmetrical cross-sectional structure. The separator SEP may have a structure in which opposite side surfaces are inversely tapered. A portion positioned on an upper surface of the separator SEP and formed of a same material or a similar material as the cathode (refer to SUE in FIG. 7; hereinafter referred to as a separator upper conductive layer or a second separator upper conductive layer) is electrically separated from the cathodes of the emission areas EDr, EDg, and EDb positioned at opposite sides of the separator SEP.

Anodes positioned in the emission areas EDr, EDg, and EDb may be electrically connected to or integral with the first driving voltage line 172 to which the first driving voltage ELVDD is applied. In FIG. 6, the first driving voltage line 172 to which the first driving voltage ELVDD is applied may have a mesh structure while extending in the first and second directions DR1 and DR2.

In an embodiment of FIG. 6, the second circuit part SC is electrically connected to an anode positioned in each light receiving area PDa through a contact hole SCo, and a cathode positioned in each light receiving area PDa is electrically separated from a cathode of each of the emission areas EDr, EDg, and EDb through a non-emissive element separator SEP-PD. In FIG. 6, the non-emissive element separator SEP-PD is illustrated in a darker color in order to be distinguished from the separator SEP. The non-emissive element separator SEP-PD may be an asymmetrical separator, and the non-emissive element separator SEP-PD may have an asymmetric cross-sectional structure. The non-emissive element separator SEP-PD may have a structure in which taper shapes and/or angles of two sides of the separator are different from each other. A reverse tapered side of the non-emissive element separator SEP-PD may be a side facing adjacent emission areas EDr, EDg, and EDb, and may be a side opposite to the side facing the light receiving area PDa. A separator upper conductive layer (SUEP in FIG. 7; hereinafter also referred to as a first separator upper conductive layer) positioned on the upper surface of the non-emissive element separator SEP-PD is connected to the cathode of the adjacent light receiving area PDa and electrically separated from the cathode of the adjacent emission areas EDr, EDg, and EDb. As a result, cathodes positioned in the separated light receiving area are electrically connected to the separator upper conductive layer disposed on the upper surface of the light receiving element separator SEP-PD through the upper conductive layer of the separator positioned on the upper surface of the separator SEP.

In FIG. 6, two types of separators SEP and SEP-PD serve to electrically separate the cathodes of the emission areas EDr, EDg, and EDb from the cathodes of the light receiving area PDa. In FIG. 6, a portion surrounded by the separators SEP and SEP-PD may correspond to one cathode, and may be the cathode of the emission areas EDr, EDg, and EDb or the light receiving area PDa. Adjacent cathodes separated by the separators SEP and SEP-PD are electrically isolated.

The cathodes of the light receiving area PDa positioned far away may be electrically connected to each other by the separator upper conductive layers SUE and SUEP positioned on the upper surfaces of the separators SEP and SEP-PD, and the upper conductive layers SUE and SUEP of the separator may also be referred to as cathode connectors. Although the cathode of the light receiving area PDa is not illustrated in FIG. 6, it is electrically connected to the second driving voltage line 179 to receive the second driving voltage ELVSS.

A schematic cross-sectional structure of the structure of FIG. 6 will be described in detail through FIG. 7.

FIG. 7 illustrates a schematic cross-sectional view showing an emissive area and a light receiving area in the embodiment of FIG. 6.

In FIG. 7, a structure in which the first circuit parts PCr, PCg, and PCb are connected to cathodes of the emission areas EDr, EDg, and EDb through the contact hole PCo, and a structure in which the second circuit part SC is connected to the anode of the light receiving area PDa through the contact hole SCo, are illustrated in detail. In FIG. 7, one of the emission areas EDr, EDg, and EDb is illustrated as the emission area ED which has the anode Anode, the cathode Cathode, and the emission layer EML.

In FIG. 7, a structure positioned under or below the planarization layers 181 and 182 is only briefly illustrated, and only one transistor is illustrated. A brief structure from the substrate 110 to the planarization layers 181 and 182 will be described as follows.

The substrate 110 may include a material that has a rigid property such as glass so as to not bend, or may include a flexible material that can be bent, such as plastic or a polyimide. In the case of a flexible substrate, it may be to have a structure in which a two-layer structure of a polyimide and a barrier layer formed of an inorganic insulating material thereon is repeatedly formed.

Lower shielding layers BML1 and BML2 containing metal may be positioned on the substrate 110, and a lower shielding layer BML1 may overlap channels of the transistors positioned in the first circuit parts PCr, PCg, and PCb included in the display unit in a plan view. According to an embodiment, at least one of the lower shielding layers BML1 and BML2 may be omitted. According to an embodiment, a lower shielding layer overlapping a channel of a sensing transistor positioned in the second circuit part SC included in the sensing unit may be further included.

The substrate 110 and the lower shielding layers BML1 and BML2 are covered by a buffer layer 111. The buffer layer 111 serves to block penetration of impurity elements into a first semiconductor layer ACT1, and may be an inorganic insulating layer including a silicon oxide ($SiO_x$), a silicon nitride ($SiN_x$), a silicon oxynitride ($SiO_xN_y$), or the like within the scope of the disclosure.

The first semiconductor layer ACT1 and a second semiconductor layer ACT2 formed of a polysilicon semiconductor (P-Si) or an oxide semiconductor are positioned on the buffer layer 111. The first semiconductor layer ACT1, which is a semiconductor layer disposed in the first circuit parts PCr, PCg, and PCb included in the display unit, may include a first region and a second region positioned at opposite sides of a channel of a transistor including a driving transistor. Herein, the transistor may be another switching transistor as well as a driving transistor belonging to the first circuit parts PCr, PCg, and PCb. The second semiconductor layer ACT2, which is a semiconductor layer disposed on the second circuit part SC included in the sensing unit, may include a first region and a second region positioned at opposite sides of a channel of a sensing transistor.

A region having a conductive layer characteristic may be provided at opposite sides of the channels of the first semiconductor layer ACT1 and the second semiconductor layer ACT2 by plasma treatment or doping, thereby serving as a first electrode and a second electrode of a transistor or sensing transistor.

A first gate insulating layer 141 may be positioned on the first semiconductor layer ACT1 and the second semiconductor layer ACT2. The first gate insulating layer 141 may include an inorganic insulating layer including a silicon oxide ($SiO_x$), a silicon nitride ($SiN_x$), a silicon oxynitride ($SiO_xN_y$), or the like within the scope of the disclosure.

A first gate conductive layer including a gate electrode GE1 of transistors positioned in the first circuit parts PCr, PCg, and PCb, and a gate electrode GE2 of a sensing transistor positioned in the second circuit part SC may be positioned on the first gate insulating layer 141,

In the first gate conductive layer, a scan line or an emission control line may be formed, or a sensing scan line connected to the second circuit part SC may be formed in addition to the gate electrodes GE1 of the transistors positioned in the first circuit parts PCr, PCg, and PCb.

The first gate conductive layer may include a first capacitor electrode CE1 positioned on the first circuit parts PCr, PCg, and PCb.

After the first gate conductive layer is formed, plasma treatment or a doping process may be performed to make an exposed region of the first semiconductor layer conductive. For example, the first semiconductor layer ACT1 covered by the gate electrode GE1 is not conductive, and a portion of the first semiconductor layer ACT1 not covered by the gate electrode GE1 may have a same characteristic as that of a conductive layer. The second semiconductor layer ACT2 covered by the gate electrode GE2 is not conductive, and a portion of the second semiconductor layer ACT2 not covered by the gate electrode GE2 may have a same characteristic as that of a conductive layer.

The transistors included in the first circuit parts PCr, PCg, and PCb and the sensing transistor included in the second circuit part SC may have a same stacked structure.

A second gate insulating layer 142 may be positioned on the first gate conductive layer and the first gate insulating layer 141. The second gate insulating layer 142 may include an inorganic insulating layer including a silicon oxide ($SiO_x$), a silicon nitride ($SiN_x$), a silicon oxynitride ($SiO_xN_y$), or the like within the scope of the disclosure.

A second gate conductive layer including a second capacitor electrode CE2 positioned on the first circuit parts PCr, PCg, and PCb may be positioned on the second gate insulating layer 142. The second capacitor electrode CE2 may constitute a capacitor positioned in the first circuit part PCr, PCg, and PCb together with the first capacitor electrode CE1, and the first capacitor electrode CE1 may be electrically connected to or integral with the gate electrode GE1 of the driving transistor.

A first interlayer insulating layer 151 may be disposed on the gate conductive layer. The first interlayer insulating layer 151 may include an inorganic insulating layer including a silicon oxide ($SiO_x$), a silicon nitride ($SiN_x$), a silicon oxynitride ($SiO_xN_y$), or the like, and according to an embodiment, an inorganic insulating material may be thickly formed.

A first data conductive layer including connecting members SE1, DE1, SE2, and DE2 may be positioned on the first interlayer insulating layer 151. A first data conductive layer may include a metal such as aluminum (Al), copper (Cu), molybdenum (Mo), titanium (Ti), or a metal alloy thereof, and may be a single layer or a multiple layer.

Herein, the connection members SE1, DE1, SE2, and DE2 may be divided into connecting members SE1 and DE1 connected to the transistors belonging to the first circuit parts PCr, PCg, and PCb, and connecting members SE2 and DE2 connected to the sensing transistor belonging to the second circuit part SC.

The connecting members SE1 and DE1 connected to the transistors belonging to the first circuit parts PCr, PCg, and PCb may include a connecting member SE1 connecting the first region of the first semiconductor layer ACT1 and the lower shielding layer BML1, and a connecting member DE1 connecting the second region of the first semiconductor layer ACT1 and the first cathode connection line CL1 formed subsequently.

The connecting members SE2 and DE2 connected to the sensing transistor belonging to the second circuit part SC may include a connecting member SE2 connected to the first region of the second semiconductor layer ACT2, and a connecting member DE2 connecting the second region of the second semiconductor layer ACT2 and the second cathode connection line CL2 formed subsequently.

A first planarization layer 181 may be disposed on the first data conductive layer. The first planarization layer 181 may be an organic insulating layer including an organic material, and may include at least one material of a polyimide, a polyamide, an acrylic resin, benzocyclobutene, and a phenol resin as an organic material.

A second data conductive layer including the first cathode connection line CL1 and the second cathode connection line CL2 may be positioned on the first planarization layer 181.

The first cathode connection line CL1 receives a current from the transistors belonging to the first circuit parts PCr, PCg, and PCb through the connecting member DE1, and the second cathode connection line CL2 is electrically connected to the sensing transistor belonging to the second circuit part SC through the connecting member DE2.

The second data conductive layer may include a data line, a first driving voltage line, a sensing line, and the like within the scope of the disclosure. A second data conductive layer may include a metal such as aluminum (Al), copper (Cu), molybdenum (Mo), titanium (Ti), or a metal alloy thereof, and may be a single layer or a multiple layer. In the embodiment of FIG. 7, the first cathode connection line CL1 and the second cathode connection line CL2 may have a triple layer structure, and the triple layer structure may have a lower layer and an upper layer including titanium (Ti), and an intermediate layer including aluminum (Al) between the lower layer and the upper layer.

A second planarization layer 182 may be positioned on the second data conductive layer, the second planarization layer 182 may be an organic insulating layer, and may each be an organic insulator, and may include at least one material of a polyimide, a polyamide, an acryl resin, benzocyclobutene, and a phenol resin.

Anodes of the emission areas EDr, EDg, and EDb, an anode Anode-pd of the light receiving area PDa, and an auxiliary connecting member Anode-co are formed on the second planarization layer 182. Herein, the auxiliary connecting member Anode-co may be formed of a same material or a similar material as that of the anodes of the emission areas EDr, EDg, and EDb and the anodes Anode-pd of the light receiving area PDa

Referring to FIG. 6, anodes of the emission areas EDr, EDg, and EDb may be electrically connected to or integral with the first driving voltage line 172 to which the first driving voltage ELVDD is applied. In an embodiment in which the first driving voltage line 172 is formed of a same material or a similar material as that of the anode, it may be integral with the anodes of the emission areas EDr, EDg, and EDb, and in an embodiment in which the first driving voltage line 172 is positioned in the second data conductive layer, it may have a structure connected to the anodes of the emission areas EDr, EDg, and EDb through an additional contact hole.

The anode anode-pd of the emission area PDa is connected to the second cathode connection line CL2 through the contact hole SCo positioned in the second planarization layer 182, to be electrically connected to the sensing transistor included in the second circuit part SC.

The auxiliary connecting member Anode-co may serve to electrically connect the cathode of the emission areas EDr, EDg, and EDb and the first cathode connection line CL1 through a contact hole PCo. According to an embodiment, in case that there is no problem in case that the cathodes of the emission areas EDr, EDg, and EDb and the first cathode connection line CL1 are electrically connected, the auxiliary connecting member Anode-co may be omitted.

On the anodes of the emission areas EDr, EDg, and EDb, the anode Anode-pd of the light receiving area PDa, and the auxiliary connecting member Anode-co, a pixel defining layer 380 having openings OPed, OPpd, and OPco covering and exposing at least portions thereof, respectively, may be positioned. The pixel defining layer 380 may be a black pixel defining layer formed of an organic material having a black color so that light applied from the outside is not reflected back to the outside, and may be formed of a transparent organic material according to an embodiment.

In the pixel defining layer 380, an opening OPed (hereinafter also referred to as a light emitting diode opening) is formed to expose the anodes of the emission areas EDr, EDg, and EDb while covering at least a portion of the anodes of the emission areas EDr, EDg, and EDb. The opening OPed of the pixel defining layer 380 may correspond to the planar structure of each of the emission areas EDr, EDg, and EDb described with reference to FIG. 6.

The pixel defining layer 380 has an opening OPpd (hereinafter referred to as a non-emissive element opening) for exposing the anode Anode-pd of the light receiving area PDa while covering at least a portion of the anode Anode-pd of the light receiving area PDa. The opening OPpd of the pixel defining layer 380 may correspond to the planar structure of the light receiving area PDa described in FIG. 6.

The pixel defining layer 380 may cover at least a portion of the auxiliary connecting member Anode-co and have an opening OPco (hereinafter also referred to as an opening for cathode contact of the light emitting diode) exposing the auxiliary connecting member Anode-co, to allow cathodes of the emission areas EDr, EDg, and EDb to be electrically connected to the first cathode connection line CL1 through the auxiliary connection member Anode-co.

Separators SEP and SEP-PD are positioned on the pixel defining layer 380. The separators SEP and SEP-PD may each have aside wall having an inverted taper structure on at least one side surface or a side surface, to cause a layer located or disposed on top of the separator SEP or SEP-PD to break near the separator SEP or SEP-PD. For example, in FIG. 7, a functional layer FL positioned on top of the separators SEP and SEP-PD and the cathode are separated from a sidewall of a reverse taper. The separators SEP and SEP-PD may be formed of a same material or a similar material as that of the pixel defining layer 380, or may be formed of a different material from that of the pixel defining layer 380 through a separate process.

By way of example, the separator SEP is a separator positioned between adjacent emission areas EDr, EDg, and EDb, and has a symmetrical structure with opposite side surfaces that are reversely tapered. As a result, the functional layer FL and the cathode adjacent to each other are separated from an upper conductive layer of the separator positioned on top of the separator SEP.

The non-emissive element separator SEP-PD may be a separator positioned between adjacent emission areas EDr, EDg, EDb and light receiving region PDa, and may have an asymmetrical structure so that taper shapes and/or angles of the two side surfaces of the non-emissive element separator SEP-PD may be different from each other. The functional layers FL and the cathode of the emission areas EDr, EDg, and EDb are electrically separated from a functional layers FL-PD and a cathode Cathode-pd of the light receiving area PDa through the non-emissive element separator SEP-PD. The cathode positioned at the upper portion of the non-emissive element separator SEP-PD is electrically connected to the cathode Cathode-pd of the light receiving area PDa. Herein, the cathode positioned on top of the non-emissive element separator SEP-PD and a separator conductive layer disposed on top of the separator SEP may be connected to each other, and cathodes Cathode-pd of the light receiving area PDa positioned far away are electrically connected to each other through cathodes positioned on top of the separator SEP and the non-emissive separator SEP-PD.

First functional layers FL-1 and FL-PD-1 are positioned on the pixel defining layer 380 and the separators SEP and SEP-PD, and the first functional layers FL-1 and FL-PD-1 have a structure in which at least first sides thereof are disconnected near the separators SEP and SEP-PD.

The emission layer EML is positioned on the first functional layer FL-1 and on the anode Anode exposed through the opening OPed of the pixel defining layer 380. A light receiving layer PSL (hereinafter also referred to as a light sensing layer or a photoelectric conversion layer) is positioned on the first functional layer FL-PD-1 and on the anode Anode-pd exposed through the opening OPpd of the pixel defining layer 380.

Second functional layers FL-2 and FL-PD-2 are positioned on the first functional layers FL-1 and FL-PD-1, the emission layer EML, and the light receiving layer PSL, and the second functional layers FL-2 and FL-PD-2 have a structure in which at least first sides thereof are disconnected near the separators SEP and SEP-PD.

The first functional layer FL-1 and the second functional layer FL-2 may contact each other where the emission layer EML is not disposed, and the first functional layer FL-PD-1 and the second functional layer FL-PD-2 may also contact each other where the light receiving layer PSL is not positioned.

Cathodes Cathode and Cathode-pd are positioned on the second functional layers FL-2 and FL-PD-2, and the cathodes Cathode and Cathode-pd are separated based on the separators SEP and SEP-PD to constitute the respective cathodes of the emission areas EDr, EDg, and EDb and the cathode Cathode-pd of the light receiving area PDa.

The functional layer FL and the emission layer EML or the functional layer FL-PD and the light receiving layer PSL may be referred to as an intermediate layer. The functional layers FL and FL-PD may include at least one of auxiliary layers such as an electron injection layer, an electron transport layer, a hole transport layer, and a hole injection layer, the first functional layers FL-1 and FL-PD-1 positioned under or below the emission layer EML and the light receiving layer PSL may include a hole injection layer and/or a hole transport layer, and the second functional layers FL-2 and FL-PD-2 positioned on the emission layer EML and the light receiving layer PSL may include an electron transport layer and/or an electron injection layer.

The light emitting diode LED of FIG. 2 may further include an anode, an emission layer EML, and a cathode, and may further include a first functional layer FL-1 positioned between the anode and the emission layer EML and a second functional layer FL-2 positioned between the emission layer EML and the cathode.

The non-emissive element PD of FIG. 4 may include an anode Anode-pd, a light receiving layer (PSL), and a cathode Cathode-pd, and may further include a first functional layer FL-PD-1 positioned between the anode Anode-pd and the light receiving layer PSL, and a second functional layer FL-PD-2 positioned between the light receiving layer PSL and the cathode Cathode-pd.

At least a portion of the cathode of the emission areas EDr, EDg, and EDb and the functional layer FL positioned therebelow overlaps the auxiliary connecting member Anode-co, and is electrically connected to the first cathode connection line CL1 through the contact hole PCo. By way of example, in the embodiment of FIG. 7, the first cathode connection line CL1 and the cathode are electrically connected in a side contact method. For example, in a triple layer structure of the first cathode connection line CL1, the intermediate layer containing aluminum (Al) is more etched than the lower and upper layers containing titanium (Ti), and the cathode and the middle layer of the first cathode connection line CL1 are electrically connected to each other by contacting each other with the auxiliary connection member Anode-co therebetween. The auxiliary connection member Anode-co may also be connected to a lower layer of the first cathode connection line CL1. Since the side contact method of FIG. 7 is one of electrical connection methods according to an embodiment, they may be electrically connected in various ways according to an embodiment.

According to an embodiment, a spacer may be further formed on the pixel defining layer 380, and the spacer may have a tapered sidewall to prevent the cathode from being disconnected.

Although a structure on the cathode is not illustrated in FIG. 7, an encapsulation layer may be disposed according to an embodiment. Herein, the encapsulation layer may include at least one inorganic layer and at least one organic layer, and may have a triple-layer structure including a first inorganic encapsulation layer, an organic encapsulation layer, and a second inorganic encapsulation layer. The encapsulation layer may be for protecting the emission layer EML and the light receiving layer PSL from moisture or oxygen that may be introduced from the outside. According to an embodiment, the encapsulation layer may include a structure in which an inorganic layer and an organic layer may be further sequentially stacked each other.

According to an embodiment, a sensing insulating layer and sensing electrodes may be positioned on the encapsulation layer for touch sensing.

According to an embodiment, a film including a polarizer may be attached on the encapsulation layer to reduce reflection of external light, or a color filter or color conversion layer may be further formed to improve color quality. A light blocking member may be positioned between color filters or color conversion layers. According to an embodiment, a layer including a material capable of absorbing some wavelengths of external light (hereinafter referred to as a reflection adjusting material) may be further included. According to an embodiment, a front surface of the emissive display device may be flattened by being covered with an additional planarization layer.

FIG. 7 illustrates a schematic cross-sectional structure according to an embodiment, so various deformable structures may be possible.

In the above, as in the embodiment of FIG. 6 and FIG. 7, the embodiment in which connection of the cathode of the light receiving area PDa is performed through the cathode positioned on top of the separators SEP and SEP-PD including the separator SEP-PD for the non-emissive element having an asymmetric structure.

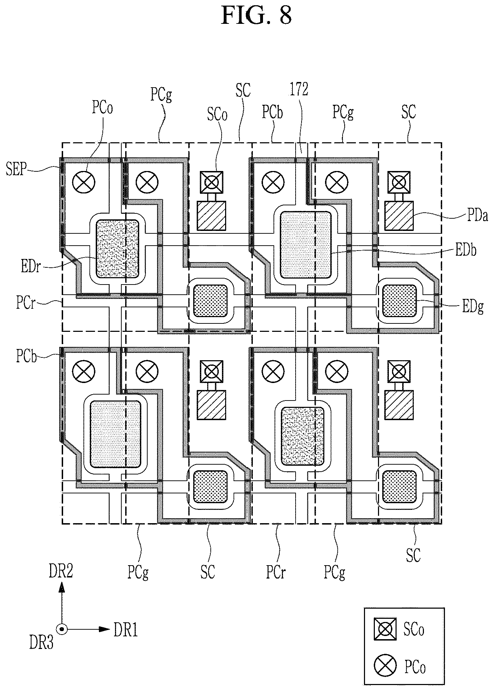

However, according to an embodiment, only a separator having a symmetrical structure may be used, and hereinafter, modifications will be described through FIG. 8 to FIG. 11.

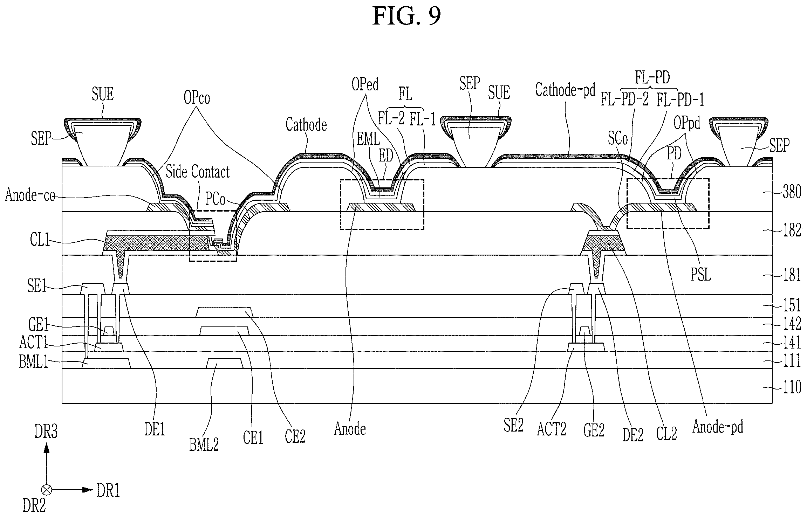

A modification will be described through FIG. 8 and FIG. 9.

FIG. 8 schematically illustrates a planar structure of an emission area and a light receiving area according to an embodiment, and FIG. 9 illustrates a schematic cross-sectional view showing an emissive area and a light receiving area in the embodiment of FIG. 8.

Hereinafter, a description will be made focusing on parts that are different from those of FIG. 6 and FIG. 7 in FIG. 8 and FIG. 9.

Referring to FIG. 8, each light receiving area PDa is not positioned within a separator SEP formed in a closed curve. Accordingly, each light receiving area PDa is not divided by the separator SEP, and has a structure in which adjacent light receiving areas PDa are connected to each other. As a result, cathodes Cathode-pd of each light receiving area PDa have a structure in which cathodes Cathode-pd of all light receiving areas PDa are integrally connected without being disconnected by the separator SEP. In the embodiment of FIG. 8, the separator SEP may serve to separate the cathodes of the emission areas EDr, EDg, and EDb from each other.

Referring to FIG. 9, a separator having an asymmetric structure may not be included, and thus all the separators may have a symmetrical cross-sectional structure, and may have a structure in which taper shapes and/or angles of opposite side surfaces are identical to each other. Only the separator SEP having all reversely tapered side surfaces is formed. As a result, the cathodes Cathode and Cathode-pd at opposite sides of the separator SEP are separated from each other, and a separator upper conductive layer SUE positioned on top of the separator SEP is also separated from the cathodes Cathode and Cathode-pd at opposite sides of the separator SEP.

According to the embodiment of FIG. 8 and FIG. 9, the cathode Cathode-pd of the light receiving area PDa is integral without being separated, but a voltage value of the second driving voltage ELVSS of the cathode Cathode-pd of the light receiving area PDa positioned in a center of the display area may drop. Accordingly, a structure in which an additional second driving voltage line is formed and connected to the cathode Cathode-pd of the light receiving area PDa at a center of the display area may be further included.

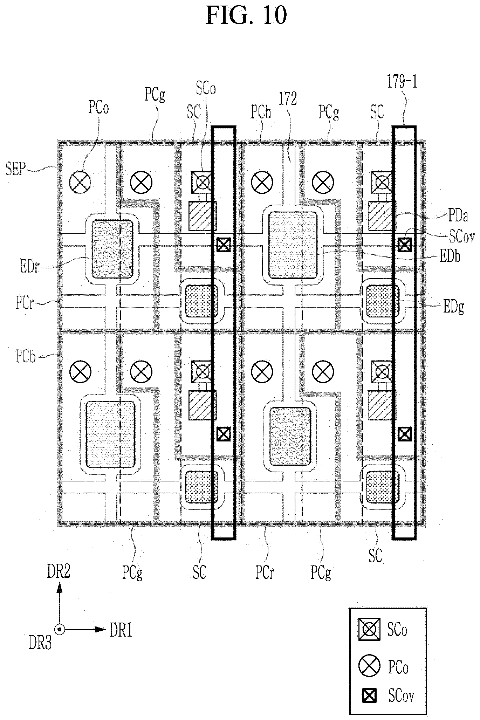

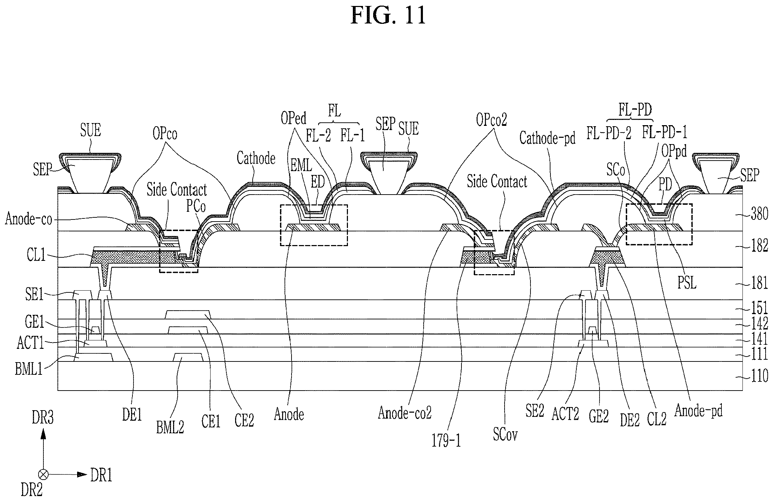

Hereinafter, another modification will be described with reference to FIG. 10 and FIG. 11.

FIG. 10 schematically illustrates a planar structure of an emission area and a light receiving area according to an embodiment, and FIG. 11 illustrates a schematic cross-sectional view showing an emissive area and a light receiving area in the embodiment of FIG. 10.

Hereinafter, a description will be made focusing on parts that are different from those of FIG. 6 and FIG. 7 in FIG. 10 and FIG. 11.

A planar structure of FIG. 10 is generally the same as the planar structure of FIG. 6, but differs only in that it is formed of a separator SEP having a symmetrical structure instead of the separator SEP-PD for the non-emissive element. In FIG. 10, unlike in FIG. 6, an additional second driving voltage line 179-1 is further included to transfer the second driving voltage ELVSS to the cathode Cathode-pd of each light receiving area PDa. For example, in FIG. 10, the cathode cathode-pd of the light-receiving area PDa and the additional second driving voltage line 179-1 are connected through a contact hole SCov so that the second driving voltage ELVSS is transferred to the cathode Cathode-pd of each light receiving area PDa.

This will be described through a schematic cross-sectional structure of FIG. 11.

Referring to FIG. 11, the second data conductive layer disposed on the first planarization layer 181 further may include an additional second driving voltage line 179-1. The additional second driving voltage line 179-1 may have a triple layer structure, and the triple layer structure may have a lower layer and an upper layer including titanium (Ti), and an intermediate layer including aluminum (Al) between the lower layer and the upper layer.

The contact hole SCov exposing the additional second driving voltage line 179-1 is formed in the second planarization layer 182, and an additional auxiliary connection member Anode-co2 is formed on the second planarization layer 182. Herein, the auxiliary connecting member Anode-co2 may be formed of a same material or a similar material as that of the anodes of the emission areas EDr, EDg, and EDb and the anodes Anode-pd of the light receiving area PDa.

The additional second driving voltage line 179-1 and the cathode of the light receiving area PDa are electrically connected through the contact hole SCov and the additional auxiliary connection member Anode-co2, and an opening OPco2 positioned at a portion corresponding to the additional auxiliary connecting member Anode-co2 is further formed in the pixel defining layer 380. By way of example, in an embodiment of FIG. 11, the additional second driving voltage line 179-1 and the cathode cathode-pd of the light receiving area PDa are electrically connected by a side contact method. For example, in the triple layer structure of the additional second driving voltage line 179-1, the intermediate layer containing aluminum (Al) is more etched than the lower and upper layers containing titanium (Ti), and the cathode Cathode-pd of the light receiving area PDa and the intermediate layer of the additional second driving voltage line 179-1 contact each other and are electrically connected with the additional auxiliary connection member Anode-co2 therebetween. The additional auxiliary connection member Anode-co2 may also be connected to a lower layer of the additional second driving voltage line 179-1. Since the side contact method of FIG. 11 is one of electrical connection methods according to an embodiment, they may be electrically connected in various ways according to an embodiment.

Similar to an embodiment of FIG. 9, an embodiment of FIG. 11 does not include a separator having an asymmetric structure, and thus all separators have symmetrical cross-sectional structures, and only the separator SEP having oppositely tapered side surfaces is formed on opposite side surfaces. As a result, the cathodes Cathode and Cathode-pd at opposite sides of the separator SEP are separated from each other, and a separator upper conductive layer SUE positioned on top of the separator SEP is also separated from the cathodes Cathode and Cathode-pd at opposite sides of the separator SEP.

In the above, the embodiment of FIG. 10 and FIG. 11 has been described.

However, according to an embodiment, the embodiment of FIG. 8 and 9 and the embodiment of FIG. 10 and 11 may be combined and used. For example, the cathodes Cathode-pd of a portion of the light receiving area PDa are not separated by the separator (SEP) and are integrally connected, and the cathodes Cathode-pd of each light receiving area PDa formed integrally receive the second driving voltage ELVSS through the additional second driving voltage line 179-1 and a separate contact hole SCov. According to this structure, even in case that a small number of contact holes (SCov) are formed, a voltage value of the second driving voltage ELVSS may be constant without changing depending on a position of the light receiving area PDa

Hereinafter, an embodiment including a sensing unit having a different circuit structure from that of FIG. 4 will be described.

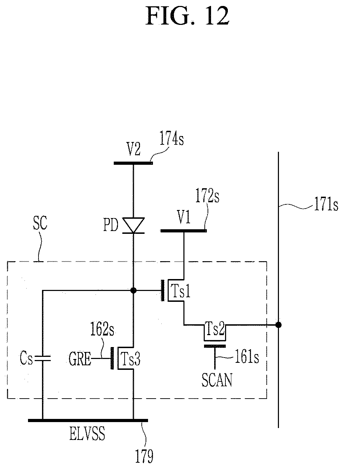

The different circuit structure of the sensing unit from that of FIG. 4 will be described through FIG. 12.

FIG. 12 illustrates a schematic diagram of an equivalent circuit diagram of one sensing unit included in an emissive display device according to an embodiment.

Unlike in FIG. 4, the sensing unit of FIG. 12 has a structure in which a terminal of the light receiving area PDa connected to a gate electrode of the first sensing transistor Ts1 is a cathode, not an anode. Hereinafter, this structure is also referred to as an inverted structure.

By way of example, the light receiving area PDa may include an anode connected to a second power voltage line 174s to which the second power voltage V2 is applied, and a cathode connected to a gate electrode of the first sensing transistor Ts1, a first electrode of the third sensing transistor Ts3, and a second electrode of the sensing capacitor Cs. The light receiving area PDa may change voltage values of the gate electrode of the first sensing transistor Ts1 and the second electrode of the sensing capacitor Cs by generating or reducing photocharges based on the intensity of external light.

Herein, the second power voltage V2 may be the first driving voltage ELVDD or the reset voltage Vreset, and may be one of other voltages having a constant level.

The third sensing transistor Ts3 (hereinafter referred to as a reset transistor) of FIG. 12 may include a gate electrode connected to the second sensing scan line 162s to which the sensing reset signal GRE is applied, a first electrode (input-side electrode) connected to the second driving voltage line 179 to which the second driving voltage ELVSS is applied, and a second electrode (output side electrode) connected to the gate electrode of the first sensing transistor Ts1, the cathode of the light receiving region PDa, and the second electrode of the sensing capacitor Cs. The third sensing transistor Ts3 serves to reset a cathode voltage of the light receiving area PDa and the voltage of the gate electrode of a first sensing transistor Ts1 to the second driving voltage ELVSS.

The first sensing transistor Ts1 (hereinafter referred to as an amplification transistor) may include a gate electrode connected to a cathode of the light receiving area PDa, a second electrode of the sensing capacitor Cs, and a second electrode of the third sensing transistor Ts3, a first electrode (input-side electrode) connected to the first power voltage line 172s to which the first power voltage V1 is applied, and a second electrode (output-side electrode) connected to a first electrode of the second sensing transistor Ts2. Herein, the first power voltage V1 may be applied to first electrodes of the first sensing transistors Ts1 of all sensing units positioned in the display area. The first sensing transistor Ts1 serves to transfer an output amplified depending on a cathode voltage of the light receiving area PDa to the second sensing transistor Ts2.

The sensing capacitor Cs may include a first electrode connected to the second driving voltage line 179, and a second electrode connected to the gate electrode of the first sensing transistor Ts1, the cathode of the light receiving area PDa, and the second electrode of the third sensing transistor Ts3. The sensing capacitor Cs serves to constantly maintain a voltage of the gate electrode of the first sensing transistor Ts1 and a voltage of the cathode of the light receiving area PDa. According to an embodiment, the first electrode of the sensing capacitor Cs is connected to a voltage line other than the second driving voltage line 179 (for example, the second power voltage line 174s to which the second power voltage V2 is applied), or the sensing capacitor Cs may be omitted.

The second sensing transistor Ts2 (hereinafter also referred to as an output transistor) may include a gate electrode connected to the first sensing scan line 161s to which a sensing scan signal SCAN is applied, a first electrode (input-side electrode) connected to the second electrode of the first sensing transistor Ts1, and a second electrode (output side electrode) connected to the sensing line 171s. The second sensing transistor Ts2 serves to output the amplified output of the first sensing transistor Ts1 to the sensing line 171s to sense it.

In an embodiment, the three sensing transistors Ts1, Ts2, and Ts3 are formed of n-type transistors, and each transistor may be turned on in case that a voltage of the gate electrode is at a high level and turned off in case that the voltage of the gate electrode is at a low level. For the semiconductor layer included in each of the transistors, a polycrystalline silicon semiconductor or an oxide semiconductor may be used, and an amorphous semiconductor or a single crystal semiconductor may be additionally used.

A second circuit of the light sensing unit illustrated in FIG. 12 is an example, and a configuration of the second circuit may be modified. A signal of a waveform illustrated in FIG. 5 may be applied to the light sensing unit of FIG. 12, and in case that the waveform of FIG. 5 is applied, an operation of the light sensing unit of FIG. 12 may be briefly described as follows.

Referring to FIG. 5, during the non-emission period, the sensing scan signal SCAN and the sensing reset signal GRE are sequentially applied to the sensing unit, and during the light-emission period in which the display unit emits light, the light receiving area PDa of the sensing unit proceeds to a light exposure period in which it is exposed to light incident after being reflected from an external object (for example, a fingerprint of a finger, which is one of user authentication means). Herein, the emission period of the display unit and the light exposure period of the sensing unit may have a same starting point and end point.

During the light exposure period, the light emitting element of the display unit emits light, and light emitted from the display unit is reflected by an external object (for example, a fingerprint of a finger) and transferred to the light receiving area PDa of the sensing unit. In case that the externally reflected light is transferred to the light receiving area PDa, the light receiving area PDa changes voltage values of the gate electrode of the first sensing transistor Ts1 and the second electrode of the sensing capacitor Cs from a previous voltage (second driving voltage ELVSS) by generating or reducing light charges based on the intensity of external light. In case that the light exposure period ends, the light receiving area PDa no longer generates or reduces photocharges, so that voltage values of the gate electrode of the first sensing transistor Ts1 and the second electrode of the sensing capacitor Cs are maintained without being changed any more.

Thereafter, the sensing scan signal SCAN is changed to a high voltage and the sensing period is entered.

The second sensing transistor Ts2 is turned on by the sensing scan signal SCAN, and an amplified output of the first sensing transistor Ts1 is outputted to the sensing line 171s. Herein, the amplified output of the first sensing transistor Ts1 is determined depending on a voltage of the gate electrode of the first sensing transistor Ts1, for example, a cathode voltage of the light receiving area PDa. The cathode voltage of the light receiving area PDa is changed depending on a magnitude of light transferred to the light receiving area PDa during the light exposure period. Accordingly, the value output from the second sensing transistor Ts2 has a value corresponding to the magnitude of light transferred to the light receiving area PDa during the light exposure period.

After the sensing scan signal SCAN changes to a low voltage, the reset period is entered while the sensing reset signal GRE changes to a high voltage.

The third sensing transistor Ts3 is turned on by the sensing reset signal GRE, and voltages of the gate electrode of the first sensing transistor Ts1, the cathode of the light receiving area PDa, and the second electrode of the sensing capacitor Cs are reset to the second driving voltage ELVSS.

Thereafter, in case that the light exposure period is entered again, as external light is transferred to the light receiving area PDa, the voltage of the cathode of the light receiving area PDa reset to the second driving voltage ELVSS is changed.

In the above, signals applied to the display unit and the sensing unit positioned in the display area have been described independently of each other, but some signals may be applied at a same timing. For example, the sensing scan signal SCAN or sensing reset signal GRE applied to the sensing unit may be applied at the same timing as one of the first scan signal GW, the second scan signal GC, the third scan signal GR, and the fourth scan signal GI applied to the display unit.

As such, in case that the display area may include both the display unit and the sensing unit, the display area may be widened by reducing the non-display area positioned outside the display area.

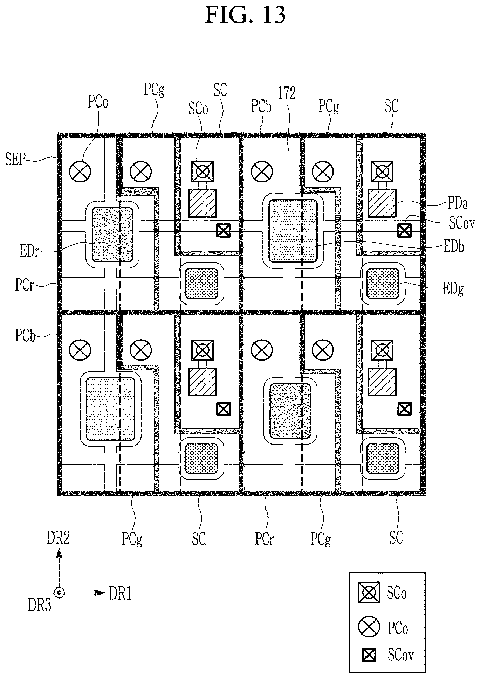

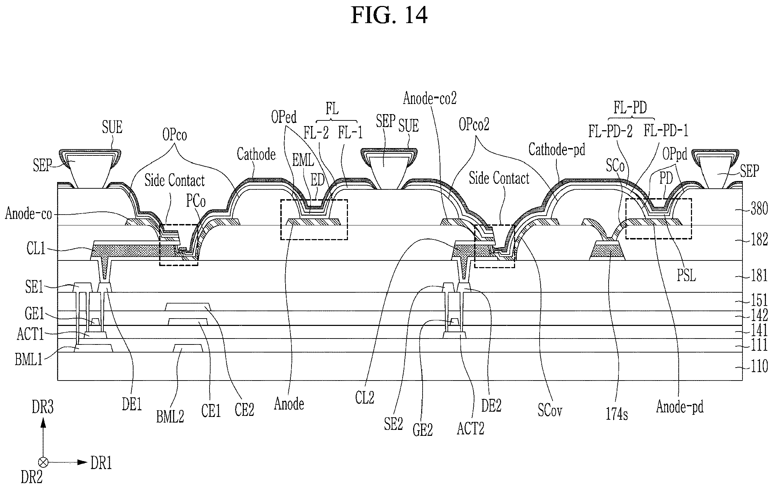

In the above, a circuit structure and an operation of the sensing unit of FIG. 12 have been described. Hereinafter, a planar structure and a cross-sectional structure of a display area including both the display unit of FIG. 2 and the sensing unit of FIG. 12 will be described through FIG. 13 and FIG. 14.

The planar structure will be described through FIG. 13.

FIG. 13 schematically illustrates a planar structure of an emission area and a light receiving area according to an embodiment.

As illustrated in FIG. 6, in FIG. 13, a total of 12 first circuit parts PCr, PCg, and PCb and second circuit parts SC adjacent to each other are schematically illustrated by dotted lines. In FIG. 13, in a first column, a red first circuit part PCr and a blue first circuit part PCb are alternately positioned in that order, in a second column, the green first circuit part PCg is continuously positioned, in a third column, the second circuit part SC is continuously positioned, in a fourth column, a blue first circuit part PCb and a red first circuit part PCr are alternately positioned in that order, in the fifth column, a first green circuit unit PCg is continuously positioned, and in the sixth column, the second circuit part SC is continuously positioned. A number and disposition of the first circuit parts PCr, PCg, and PCb and the second circuit parts SC may be variously changed.

On the first circuit parts PCr, PCg, and PCb and the second circuit parts SC, the emission areas EDr, EDg, and EDb and the light receiving area PDa respectively connected thereto are positioned.

A connection structure between the first circuit parts PCr, PCg, and PCb and the emission areas EDr, EDg, and EDb is not different from that of FIG. 6. Hereinafter, the connection structure of the second circuit part SC will be described in detail.

In the embodiment of FIG. 13, the second power voltage line 174s of the second circuit part SC is electrically connected to the anode of each light receiving area PDa through the contact hole SCo, and in the embodiment, the sensing transistor of the second circuit part SC is electrically connected to the cathode of each light receiving area PDa through the contact hole SCov. It is electrically separated from the cathode of each emission areas EDr, EDg, and EDb and the cathode of each light receiving region PDa through the separator SEP. All of the separators SEP illustrated in FIG. 13 may be symmetrical separators, and both side surfaces may have a reverse tapered structure.

A schematic cross-sectional structure of the structure of FIG. 13 will be described in detail through FIG. 14.

FIG. 14 illustrates a schematic cross-sectional view showing an emissive area and a light receiving area in the embodiment of FIG. 13.

Since the structure of FIG. 14 is the same as that of FIG. 7 from the substrate 110 to the first planarization layer 181, a description thereof may be omitted.

The second data conductive layer including the first cathode connection line CL1, the second cathode connection line CL2, and the second power voltage line 174s (see FIG. 12) may be positioned on the first planarization layer 181.

The first cathode connection line CL1 receives a current from the transistors belonging to the first circuit parts PCr, PCg, and PCb through the connecting member DE1, and the second cathode connection line CL2 is electrically connected to the sensing transistor belonging to the second circuit part SC through the connecting member DE2. The second power voltage line 174s is a voltage line that transmits the second power voltage V2, and according to an embodiment, the second power voltage line 174s may be the first driving voltage line 172 to which the first driving voltage ELVDD is applied or the reset voltage line 173s to which the reset voltage Vreset is applied.

The second data conductive layer may include a data line, a sensing line, and the like within the scope of the disclosure. A second data conductive layer may include a metal such as aluminum (Al), copper (Cu), molybdenum (Mo), titanium (Ti), or a metal alloy thereof, and may be a single layer or a multiple layer. In the embodiment of FIG. 7, the first cathode connection line CL1 and the second cathode connection line CL2 may have a triple layer structure, and the triple layer structure may have a lower layer and an upper layer including titanium (Ti), and an intermediate layer including aluminum (Al) between the lower layer and the upper layer.

A second planarization layer 182 may be positioned on the second data conductive layer, the second planarization layer 182 may be an organic insulating layer, and may each be an organic insulator, and may include at least one material of a polyimide, a polyamide, an acryl resin, benzocyclobutene, and a phenol resin.

Anodes of the emission areas EDr, EDg, and EDb, an anode Anode-pd of the light receiving area PDa, and auxiliary connecting members Anode-co and Anode-co2 are formed on the second planarization layer 182. Herein, the auxiliary connecting members Anode-co and Anode-co2 may be formed of a same material or a similar material as that of the anodes of the emission areas EDr, EDg, and EDb and the anodes Anode-pd of the light receiving area PDa.

Referring to FIG. 6, anodes of the emission areas EDr, EDg, and EDb may be electrically connected to or integral with the first driving voltage line 172 to which the first driving voltage ELVDD is applied. In an embodiment in which the first driving voltage line 172 is formed of a same material or a similar material as that of the anode, it may be integral with the anodes of the emission areas EDr, EDg, and EDb, and in an embodiment in which the first driving voltage line 172 is positioned in the second data conductive layer, it may have a structure connected to the anodes of the emission areas EDr, EDg, and EDb through an additional contact hole.

The anode Anode-pd of the light receiving area PDa is connected to the second power voltage line 174s through the contact hole SCo positioned in the second planarization layer 182.

The auxiliary connecting member Anode-co may serve to electrically connect the cathode of the emission areas EDr, EDg, and EDb and the first cathode connection line CL1 through a contact hole PCo. According to an embodiment, in case that there is no problem in case that the cathodes of the emission areas EDr, EDg, and EDb and the first cathode connection line CL1 are electrically connected, the auxiliary connecting member Anode-co may be omitted.

The additional auxiliary connection member Anode-co2 may serve as an auxiliary aid to electrically connect the cathode Cathode-pd of the light receiving area PDa and the second cathode connection line CL2 through the contact hole SCov. According to an embodiment, in case that there is no problem in case that the cathode Cathode-pd of the light receiving area PDa and the second cathode connection line CL2 are electrically connected, the additional auxiliary connecting member Anode-co2 may be omitted.

On the anodes of the emission areas EDr, EDg, and EDb, the anode Anode-pd of the light receiving area PDa, and the auxiliary connecting member Anode-co and Anode-co2, a pixel defining layer 380 having openings OPed, OPpd, OPco, and OPco2 covering and exposing at least portions thereof, respectively, may be positioned. The pixel defining layer 380 may be a black pixel defining layer formed of an organic material having a black color so that light applied from the outside is not reflected back to the outside, and may be formed of a transparent organic material according to an embodiment.

In the pixel defining layer 380, an opening OPed (hereinafter also referred to as a light emitting diode opening) is formed to expose the anodes of the emission areas EDr, EDg, and EDb while covering at least a portion of the anodes of the emission areas EDr, EDg, and EDb. The opening OPed of the pixel defining layer 380 may correspond to the planar structure of each of the emission areas EDr, EDg, and EDb described with reference to FIG. 13.

The pixel defining layer 380 has an opening OPpd (hereinafter referred to as a non-emissive element opening) for exposing the anode Anode-pd of the light receiving area PDa while covering at least a portion of the anode Anode-pd of the light receiving area PDa. The opening OPpd of the pixel defining layer 380 may correspond to the planar structure of the light receiving area PDa described in FIG. 13.

The pixel defining layer 380 covers at least a portion of the auxiliary connecting member Anode-co and has an opening OPco (hereinafter also referred to as an opening for cathode contact of the light emitting diode) exposing the auxiliary connecting member Anode-co allow cathodes of the emission areas EDr, EDg, and EDb to be electrically connected to the first cathode connection line CL1 through the auxiliary connection member Anode-co. As a result, the cathodes of the emission areas EDr, EDg, and EDb are electrically connected to the transistors included in the first circuit parts PCr, PCg, and PCb.

The pixel defining layer 380 may cover at least a portion of the additional auxiliary connection member Anode-co2 and have an opening OPco2 (hereinafter also referred to as an opening for a cathode contact of a non-emissive element) exposing the additional auxiliary connection member Anode-co2, to electrically connect the cathode Cathode-pd of the light receiving area PDa and the second cathode connection line CL2 through the additional auxiliary connection member Anode-co2. As a result, the cathode Cathode-pd of the light receiving area PDa is electrically connected to the sensing transistor included in the second circuit part SC.

The separator SEP is positioned on the pixel defining layer 380. The separator SEP is a separator positioned between adjacent emission areas EDr, EDg, and EDb and the light receiving area PDa, and has a symmetrical structure with opposite side surfaces that are reversely tapered. As a result, it has a structure in which the adjacent functional layer and the cathode are separated by the separator SEP. The functional layer and the cathode adjacent to the separator SEP may be separated from the separator upper conductive layer SUE disposed on the separator SEP.

The separator SEP may be formed of a same material or a similar material as that of the pixel defining layer 380, or may be formed of a different material from that of the pixel defining layer 380 through a separate process.

First functional layers FL-1 and FL-PD-1 are disposed on the pixel defining layer 380 and the separator SEP, and the first functional layers FL-1 and FL-PD-1 have a structure disconnected near the separator SEP.

The emission layer EML is positioned on the first functional layer FL-1 and on the anode Anode exposed through the opening OPed of the pixel defining layer 380. A light receiving layer PSL is positioned on the first functional layer FL-PD-1 and on the anode Anode-pd exposed through the opening OPpd of the pixel defining layer 380.

Second functional layers FL-2 and FL-PD-2 are positioned on the first functional layers FL-1 and FL-PD-1, the emission layer EML, and the light receiving layer PSL, and the second functional layers FL-2 and FL-PD-2 have a structure disconnected near the separator SEP.

The first functional layer FL-1 and the second functional layer FL-2 may contact each other where the emission layer EML is not disposed, and first functional layer FL-PD-1 and the second functional layer FL-PD-2 may also contact each other where the light receiving layer PSL is not positioned.

Cathodes Cathode and Cathode-pd are positioned on the second functional layers FL-2 and FL-PD-2, and the cathodes Cathode and Cathode-pd are separated based on the separator SEP to constitute the respective cathodes of the emission areas EDr, EDg, and EDb and the cathode Cathode-pd of the light receiving area PDa.

The functional layer FL and the emission layer EML or the functional layer FL-PD and the light receiving layer PSL may be referred to as an intermediate layer. The functional layers FL and FL-PD may include at least one of auxiliary layers such as an electron injection layer, an electron transport layer, a hole transport layer, and a hole injection layer, the first functional layers FL-1 and FL-PD-1 positioned under or below the emission layer EML and the light receiving layer PSL may include a hole injection layer and/or a hole transport layer, and the second functional layers FL-2 and FL-PD-2 positioned on the emission layer EML and the light receiving layer PSL may include an electron transport layer and/or an electron injection layer.

The light emitting diode LED may further include an anode, an emission layer EML, and a cathode, and may further include a first functional layer FL-1 positioned between the anode and the emission layer EML and a second functional layer FL-2 positioned between the emission layer EML and the cathode.

The non-emissive element PD of FIG. 12 may include an anode Anode-pd, a light receiving layer (PSL), and a cathode Cathode-pd, and may further include a first functional layer FL-PD-1 positioned between the anode Anode-pd and the light receiving layer PSL, and a second functional layer FL-PD-2 positioned between the light receiving layer PSL and the cathode Cathode-pd.

At least a portion of the cathode of the emission areas EDr, EDg, and EDb and the functional layer FL positioned therebelow overlaps the auxiliary connecting member Anode-co, and is electrically connected to the first cathode connection line CL1 through the contact hole PCo. By way of example, in the embodiment of FIG. 14, the first cathode connection line CL1 and the cathode are electrically connected in a side contact method. For example, in a triple layer structure of the first cathode connection line CL1, the intermediate layer containing aluminum (Al) is more etched than the lower and upper layers containing titanium (Ti), and the cathode and the middle layer of the first cathode connection line CL1 are electrically connected to each other by contacting each other with the auxiliary connection member Anode-co therebetween. The auxiliary connection member Anode-co may also be connected to a lower layer of the first cathode connection line CL1. Since the side contact method of FIG. 14 is one of electrical connection methods according to an embodiment, they may be electrically connected in various ways according to an embodiment.

The second cathode connection line CL2 and the cathode Cathode-pd of the light receiving area PDa are electrically connected in a side contact method. For example, in the triple layer structure of the second cathode connection line CL2, the intermediate layer containing aluminum (Al) is more etched than the lower and upper layers containing titanium (Ti), and the cathode Cathode-pd of the light receiving area PDa and the intermediate layer of the second cathode connection line CL2 contact each other and are electrically connected with the additional auxiliary connection member Anode-co2 therebetween. The additional auxiliary connection member Anode-co2 may also be connected to a lower layer of the second cathode connection line CL2. Since the side contact method of FIG. 14 is one of electrical connection methods according to an embodiment, they may be electrically connected in various ways according to an embodiment.

Similar to an embodiment of FIG. 9, embodiments of FIG. 7 and FIG. 14 do not include a separator having an asymmetric structure, and thus all separators have symmetrical cross-sectional structures, and only the separator SEP having oppositely tapered side surfaces is formed on opposite side surfaces. As a result, the cathodes Cathode and Cathode-pd at opposite sides of the separator SEP are separated from each other, and a separator upper conductive layer SUE positioned on top of the separator SEP is also separated from the cathodes Cathode and Cathode-pd at opposite sides of the separator SEP.

According to an embodiment, a spacer may be further formed on the pixel defining layer 380, and the spacer may have a tapered sidewall to prevent the cathode from being disconnected.

Although a structure on the cathode is not illustrated in FIG. 14, an encapsulation layer may be disposed according to an embodiment. Herein, the encapsulation layer may include at least one inorganic layer and at least one organic layer, and may have a triple-layer structure including a first inorganic encapsulation layer, an organic encapsulation layer, and a second inorganic encapsulation layer. The encapsulation layer may be for protecting the emission layer EML and the light receiving layer PSL from moisture or oxygen that may be introduced from the outside. According to an embodiment, the encapsulation layer may include a structure in which an inorganic layer and an organic layer may be further sequentially stacked each other.

According to an embodiment, a sensing insulating layer and sensing electrodes may be positioned on the encapsulation layer for touch sensing.

According to an embodiment, a film including a polarizer may be attached on the encapsulation layer to reduce reflection of external light, or a color filter or color conversion layer may be further formed to improve color quality. A light blocking member may be positioned between color filters or color conversion layers. According to an embodiment, a layer including a material capable of absorbing some wavelengths of external light (hereinafter referred to as a reflection adjusting material) may be further included. According to an embodiment, a front surface of the emissive display device may be flattened by being covered with an additional planarization layer.

FIG. 13 and FIG. 14 illustrates a planar structure and a cross-sectional structure according to an embodiment, thus, various deformable structures may be possible.

While this disclosure has been described in connection with what is considered to be practical embodiments, it is to be understood that the disclosure is not limited to the disclosed embodiments, but, on the contrary, is intended to cover various modifications and equivalent arrangements included and within the scope of the appended claims.

## Claims

1. An emissive display device comprising:

   a light emitting diode that includes a first circuit part disposed in a display area and a cathode electrically connected to the first circuit part; and
   a non-emissive element that includes a second circuit part disposed in the display area and a cathode electrically connected to the second circuit part,
   wherein the cathode of the non-emissive element is separated from the cathode of the light emitting diode by a separator.

2. The emissive display device of claim 1, wherein the separator surrounds the cathode of the non-emissive element, and includes a non-emissive element separator having a substantially tapered shape or a substantially different angle at opposite sides.

3. The emissive display device of claim 2, wherein

   the cathode of the non-emissive element is electrically connected to a first separator upper conductive layer disposed on top of the non-emissive element separator, and
   the first separator upper conductive layer disposed on top of the non-emissive separator and a second separator upper conductive layer disposed on top of the separator are electrically connected to each other, and
   the cathode of the non-emissive element is electrically connected to a cathode of another non-emissive element disposed at a distance from the cathode of the non-emissive element through the second separator upper conductive layer disposed on top of the separator and the first separator upper conductive layer disposed on top of the non-emissive element separator.

4. The emissive display device of claim 1, wherein the separator surrounds the cathode of the non-emissive element, and has a same substantially tapered shape or substantially an angle on opposite side surfaces.

5. The emissive display device of claim 4, wherein a cathode disposed in a light receiving area where the non-emissive element is disposed is integral with a cathode of another non-emissive element disposed at a distance from the light receiving area without being separated by the separator.

6. The emissive display device of claim 1, wherein the separator surrounds each of the cathode of the light emitting diode and the cathode of the non-emissive element, and has substantially reversely tapered sidewalls on opposite side surfaces.

7. The emissive display device of claim 6, further comprising:
   an additional second driving voltage line electrically connected to the cathode of the light receiving diode through a contact hole to transfer a second driving voltage.

8. The emissive display device of any preceding claim, wherein
   an anode of the light emitting diode is configured to receive a first driving voltage, and the cathode of the non-emissive element is configured to receive a second driving voltage.

9. The emissive display device of claim 8, wherein the second circuit part includes:

   a first sensing transistor that includes a gate electrode electrically connected to an anode of the non-emissive element, a first electrode to which a common voltage is transferred, and a second electrode;

a second sensing transistor that includes a gate electrode, a first electrode electrically connected to the second electrode of the first sensing transistor, and a second electrode electrically connected to a sensing line; and
a third sensing transistor that includes a gate electrode, a first electrode to which a reset voltage is applied, and a second electrode electrically connected to the anode of the non-emissive element; and
wherein optionally the first circuit part includes:

a first transistor that includes a gate electrode, a first electrode, and a second electrode;
a second transistor that includes a gate electrode, a first electrode electrically connected to a data line, and a second electrode electrically connected to the gate electrode of the first transistor;
a fifth transistor that includes a gate electrode, a first electrode electrically connected to the cathode of the light emitting diode, and a second electrode electrically connected to the first electrode of the first transistor; and
a sixth transistor that includes a gate electrode, a first electrode electrically connected to the second electrode of the first transistor, and a second electrode receiving a second driving voltage.

10. The emissive display device of claim 9, wherein at least one of the first transistor, the second transistor, the fifth transistor, and the sixth transistor of the first circuit part and at least one of the first sensing transistor, the second sensing transistor, and the third sensing transistor of the second circuit part have substantially a same stacked structure;
and wherein the emissive display device optionally further comprises:

a cathode connecting member that electrically connects the first electrode of the fifth transistor and the cathode of the light emitting element,
wherein the cathode connecting member has a three-layer structure, and
the cathode connecting member and the cathode of the light emitting diode are electrically connected by a side contact.

11. An emissive display device comprising:

a display part that includes a first circuit part disposed in a display area and a light emitting diode electrically connected to the first circuit part; and
a sensing part that includes a second circuit part disposed in the display area and a non-emissive element electrically connected to the second circuit part, wherein
a cathode of the light emitting diode is electrically connected to the first circuit part, and
a cathode of the non-emissive element is electrically connected to the second circuit part.

12. The emissive display device of claim 11, wherein

an anode of the light emitting diode is configured to receive a first driving voltage, and
an anode of the non-emissive element is configured to receive a first voltage;
and wherein optionally the second circuit part includes:

a first sensing transistor that includes a gate electrode electrically connected to a cathode of the non-emissive element, a first electrode to which a common voltage is transferred, and a second electrode;
a second sensing transistor that includes a gate electrode, a first electrode electrically connected to the second electrode of the first sensing transistor, and a second electrode electrically connected to a sensing line; and
a third sensing transistor that includes a gate electrode, a first electrode to which a second driving voltage is applied, and a second electrode electrically connected to the cathode of the non-emissive element.

13. The emissive display device of claim 12, wherein the first circuit part includes:

a first transistor that includes a gate electrode, a first electrode, and a second electrode;
a second transistor that includes a gate electrode, a first electrode electrically connected to a data line, and a second electrode electrically connected to the gate electrode of the first transistor;
a fifth transistor that includes a gate electrode, a first electrode electrically connected to the cathode of the light emitting diode, and a second electrode electrically connected to the first electrode of the first transistor; and
a sixth transistor that includes a gate electrode, a first electrode electrically connected to the second electrode of the first transistor, and a second electrode receiving a second driving voltage;
and wherein optionally at least one of the first transistor, the second transistor, the fifth transistor, and the sixth transistor of the first circuit part and at least one of the first sensing transistor, the second sensing transistor, or the third sensing transistor of the second circuit part have substantially a same stacked structure.

14. The emissive display device of claim 13, further comprising:
a cathode connecting member that electrically connects the first electrode of the fifth transistor and the cathode of the light emitting element, wherein:

the cathode connecting member has a three-layer structure, and
the cathode connecting member and the cathode of the light emitting diode are connected by a side contact.

15. The emissive display device of claim 11, wherein the cathode of the light emitting diode and the cathode of the non-emissive element are separated from each other by a separator, and wherein optionally the separator surrounds each of the cathode of the light emitting diode and the cathode of the non-emissive element, and has a substantially reversely tapered sidewalls on opposite side surfaces.

# FIG. 1

# FIG. 2

# FIG. 3

# FIG. 4

# FIG. 5

# FIG. 6

EP 4 366 484 A1

# FIG. 7

# FIG. 8

# FIG. 9

EP 4 366 484 A1

# FIG. 10

# FIG. 11

EP 4 366 484 A1

# FIG. 12

## FIG. 13

# FIG. 14

EP 4 366 484 A1

**Europäisches Patentamt**
**European Patent Office**
**Office européen des brevets**

# EUROPEAN SEARCH REPORT

Application Number

EP 23 20 5882

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 065 587 A (BOE TECHNOLOGY GROUP CO LTD) 21 December 2018 (2018-12-21) | 1,8, 10-12,15 | INV. H10K59/122 H10K59/65 |
| Y | * paragraphs [0031], [0037], [0042], [0053] – [0054]; figure 2 * | 6,9 | |
| | ----- | | ADD. H10K59/131 |
| X | CN 112 701 224 A (WUHAN CHINA STAR OPTOELECTRONICS SEMICONDUCTOR DISPLAY TECH CO LTD) 23 April 2021 (2021-04-23) | 1,2,4,8, 10-12,15 | |
| Y | * paragraphs [0020], [0047], [0069] – [0076], [0081]; figure 5 * | 6,9 | |
| | ----- | | |
| Y | US 2005/046341 A1 (IKEDA NAMI [JP] ET AL) 3 March 2005 (2005-03-03) * paragraph [0067]; figure 1 * | 6 | |
| | ----- | | |
| Y | US 2022/294981 A1 (KUBOTA DAISUKE [JP] ET AL) 15 September 2022 (2022-09-15) * paragraph [0295]; figure 16A * | 9 | |
| | ----- | | |
| | | | TECHNICAL FIELDS SEARCHED (IPC) |
| | | | H10K |

The present search report has been drawn up for all claims

| Place of search | Date of completion of the search | Examiner |
|---|---|---|
| Munich | 11 March 2024 | Beierlein, Udo |

EPO FORM 1503 03.82 (P04C01)

## ANNEX TO THE EUROPEAN SEARCH REPORT
## ON EUROPEAN PATENT APPLICATION NO.

EP 23 20 5882

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2024

| Patent document cited in search report | | Publication date | Patent family member(s) | | Publication date |
|---|---|---|---|---|---|
| CN 109065587 | A | 21-12-2018 | NONE | | |
| CN 112701224 | A | 23-04-2021 | NONE | | |
| US 2005046341 | A1 | 03-03-2005 | CN | 1592515 A | 09-03-2005 |
| | | | JP | 4538649 B2 | 08-09-2010 |
| | | | JP | 2005071656 A | 17-03-2005 |
| | | | TW | I271697 B | 21-01-2007 |
| | | | US | 2005046341 A1 | 03-03-2005 |
| US 2022294981 | A1 | 15-09-2022 | CN | 114365474 A | 15-04-2022 |
| | | | JP | WO2021048683 A1 | 18-03-2021 |
| | | | KR | 20220063195 A | 17-05-2022 |
| | | | US | 2022294981 A1 | 15-09-2022 |
| | | | WO | 2021048683 A1 | 18-03-2021 |

EPO FORM P0459

For more details about this annex : see Official Journal of the European Patent Office, No. 12/82